# EUROPEAN PATENT APPLICATION

(11) **EP 2 068 480 A1**
(43) Date of publication of application: **10.06.2009**
(21) Application number: 07806752.7
(22) Date of filing: 05.09.2007
(51) Int. Cl.: H04L 1/00, H04B 1/707, H04J 11/00

(54) **TRANSMISSION/RECEPTION DEVICE, TRANSMISSION/RECEPTION SYSTEM, AND TRANSMISSION/RECEPTION METHOD**

(30) Priority: 06.09.2006 JP 2006241674
(71) Applicant: Sharp Kabushiki Kaisha, Osaka-shi, Osaka 545-8522 (JP)
(72) Inventor: YOSHIMOTO, Takashi, Chiba-shi, Chiba-ken (JP); YAMADA, Ryota, Chiba-shi, Chiba-ken (JP); NOGAMI, Toshizo, Chiba-shi, Chiba-ken (JP)
(74) Representative: Müller - Hoffmann & Partner
(86) International application number: PCT/JP2007/067309
(87) International publication number: WO 2008/029845

(57) **Abstract**

A transmission-and-reception apparatus of the present invention includes: a receiver that receives category information concerning a function of another transmission-and-reception apparatus; a selector that selects an interleaving scheme based on the category information; and an interleaver that interleaves signals to be transmitted to the other transmission-and-reception apparatus based on the selected interleaving scheme. Thereby, the maximum performance of each reception apparatus can be achieved even when reception apparatuses belonging to multiple categories are included in a wireless communication system.

## Description

### TECHNICAL FIELD

The present invention relates to a transmission-and-reception apparatus, a transmission-and-reception system, and a transmission-and-reception method, and particularly to a transmission-and-reception apparatus, a transmission-and-reception system, and a transmission-and-reception method for transmitting and receiving interleaved signals.
Priority is claimed on Japanese Patent Application No. 2006-241674, filed September 6, 2006, the content of which is incorporated herein by reference.

### BACKGROUND ART

In an MC-CDM (Multi-Carrier Code Division Multiplexing) system, an OFDM (Orthogonal Frequency and Code Division Multiplexing) system, and the like, a transmitter encodes information data with turbo codes, copies information symbols subjected to data modulation, such as QPSK (Quadrature Phase Shift Keying) or 16 QAM (16 Quadrature Amplitude Modulation), to continuous subcarriers corresponding to spreading factors, and multiplies the subcarriers by spreading codes (hereinafter called "frequency spreading"). Since symbols on the subcarriers are frequency-spread with splittable spreading codes, code multiplexing is enabled. A receiver performs inverse spreading using the spreading codes corresponding to the desired symbols to extract the desired symbols, restores information transmitted over the subcarriers, and thereby performs demodulation. In the MC-CDMA and OFCDM systems, encoded and spread symbols are assigned to subcarriers. Thereby, the frequency diversity effect caused by variation in amplitude and phase of each subcarrier can be achieved in frequency selective fading under circumstances of mobile communication. For example, Non-patent Document 1 discloses the MC-CDMA and OFCDM systems.

There is a technique called interleaving as a method of achieving the frequency diversity effect irrespective of the level of the frequency selective fading (such as the level of delay dispersion). In this technique, information symbols are rearranged based on a given pattern and then transmitted. On a receiving side, rearrangement is performed based on the reverse pattern of the given pattern to disperse the risk of signal degradation and thereby to restore the transmitted information symbols more precisely.
There are multiple interleaving schemes according to signals targeted for interleaving, such as bit interleaving, symbol interleaving, or chip interleaving, which are disclosed in Non-patent Document 1.
Conventionally, a technique has been known by which an efficient selection is enabled by an interleaving scheme being selected based on communication circumstances since interleaving effects to be achieved differ depending on communication circumstances of the MC-CDM system (see, for example, Non-patent Document 1). For example, chip interleaving achieving a great frequency diversity effect but causing great destruction of orthogonality is not selected in some cases where the code multiplexing number is large. The communication circumstances are, for example, the maximum Doppler frequency, delay dispersion, transmission parameters (modulation level, the code multiplexing number, spreading factors).
Non-patent Document 1: Maeda, Atarashi, Abeta, and Sawahashi, "VSF-OFCDM Using Two-Dimensional Spreading and Its Performance", Technical report of IEICE, RCS200258, May 2002
Patent Document 1: Japanese Unexamined Patent Application, Fast Publication No. 2005-210708

### DISCLOSURE OF THE INVENTION

### Problems to be Solved by the Invention

Receiving apparatuses present in a wireless communication system can be categorized based on the type or amount of target data. It can be considered that receiving apparatuses belonging to multiple categories are present in the same wireless communication system. For example, a function and performance of a receiving apparatus differ according to whether a category to which the receiving apparatus belongs is dedicated for audio or moving pictures. Accordingly, there might be cases where destruction of orthogonality of spreading factors caused by chip interleaving has a great effect in one category, but has a small effect in another category. For this reason, a problem arises in that reception performance of a receiving apparatus belonging to one category is restricted and that of another apparatus belonging to another category is enhanced when a conventional method of selecting an interleaving scheme based on communication circumstances is used.

The present invention is made in consideration of the above situations. The objects thereof are to provide a transmission-and-reception apparatus, a transmission-and-reception system, and a transmission-and-reception method by which excellent reception performance of each transmission-and-reception apparatus can be achieved even when transmission-and-reception apparatuses belonging to multiple categories perform reception.

### Means for Solving the Problems

To solve the problems, a transmission-and-reception apparatus according to one aspect of the present invention includes: a receiver that receives category information concerning a function of another transmission-and-reception apparatus as a target apparatus; a selector that selects an interleaving scheme based on the category information; and an interleaver that interleaves signals to be transmitted to the other transmission-and-reception apparatus based on the interleaving scheme.

Accordingly, the transmission-and-reception apparatus of the present invention selects an interleaving scheme based on the category information so as to be suited to a category specified by the category information. Thereby, the transmission-and-reception apparatus can transmit signals achieving excellent reception performance of another transmission-and-reception apparatus.

The transmission-and-reception apparatus may further include a control-signal multiplexer that generates a control signal including information indicative of the interleaving scheme, and multiplexes the signals interleaved and the control signal.

The transmission-and-reception apparatus may further include a code multiplexer that multiplies a plurality of code channel signals respectively by unique spreading codes, and multiplexes the code channel signals to generate the signals to be transmitted.

A transmission-and-reception apparatus according to another aspect of the present invention includes: a transmitter that transmits category information concerning a function of the transmission-and-reception apparatus as a target apparatus; and a deinterleaver that deinterleaves reception signals based on an interleaving scheme corresponding to the category information.

A transmission-and-reception apparatus according to another aspect of the present invention includes: a transmitter that transmits category information concerning a function of the transmission-and-reception apparatus as a target apparatus; a control-signal demodulator that demodulates a control signal received and extracts information indicative of an interleaving scheme; and a deinterleaver that deinterleaves reception signals based on the interleaving scheme.

The transmission-and-reception apparatus may further include a code demultiplexer that multiplies the reception signals deinterleaved by spreading codes to extract code channel signals corresponding to the spreading codes.

In the transmission-and-reception apparatus, the category information may include information indicating whether or not an interference canceller that cancels interference signals from signals received from the target apparatus is included.

In the transmission-and-reception apparatus, the category information may include grade information indicative of capacity of the interference canceller.

In the transmission-and-reception apparatus, the grade information may be based on the repetition number of processing performed by the interference canceller.

In the transmission-and-reception apparatus, the grade information is based on an interleaving scheme used by the interference canceller.

In the transmission-and-reception apparatus, the category information may include information based on a frequency bandwidth used by the target apparatus, a modulation level for transmission, a code multiplexing number, or a repetition number of error correction decoding.

A transmission-and-reception system according to another aspect of the present invention includes a first transmission-and-reception apparatus and a second transmission-and-reception apparatus that transmits interleaved signals to the first transmission-and-reception apparatus. The first transmission-and-reception apparatus includes: a transmitter that transmits category information concerning a function of the first transmission-and-reception apparatus; and a deinterleaver that deinterleaves the interleaved signals based on an interleaving scheme corresponding to the category information. The second transmission-and-reception apparatus may include: a receiver that receives the category information; a selector that selects an interleaving scheme based on the category information received; and an interleaver that interleaves signals to be transmitted to the first transmission-and-reception apparatus based on the interleaving scheme selected to generate the interleaved signals.

A transmission-and-reception system according to another aspect of the present invention includes a first transmission-and-reception apparatus and a second transmission-and-reception apparatus that transmits interleaved signals to the first transmission-and-reception apparatus. The first transmission-and-reception apparatus includes: a transmitter that transmits category information concerning a function of the first transmission-and-reception apparatus; a control-signal demodulator that demodulates a control signal multiplexed into the interleaved signals received and extracts information indicative of an interleaving scheme; and a deinterleaver that deinterleaves the interleaved signals received based on the interleaving scheme extracted. The second transmission-and-reception apparatus includes: a receiver that receives the category information; a selector that selects an interleaving scheme based on the category information received; an interleaver that interleaves signals to be transmitted to the first transmission-and-reception apparatus based on the interleaving scheme selected to generate the interleaved signals; and a control-signal multiplexer that generates a control signal including information indicative of the interleaving scheme selected, and multiplexes the interleaved signals and the control signal.

A transmission-and-reception method according to another aspect of the present invention is for a transmission-and-reception system including a transmitter that transmits interleaved signals and a receiver that receives the interleaved signals. The transmission-and-reception method includes: a first step of the receiver transmitting category information concerning a function of the receiver; a second step of the transmitter receiving the category information; a third step of the transmitter selecting an interleaving scheme based on the category information received; a fourth step of the transmitter performing interleaving based on the interleaving scheme selected to generate the interleaved signals; and a fifth step of the receiver receiving and deinterleaving the interleaved signals based on an interleaving scheme corresponding to the category information.

A transmission-and-reception method according to another aspect of the present invention is for a transmission-and-reception system including a transmitter that transmits interleaved signals and a receiver that receives the interleaved signals. The transmission-and-reception method includes: a first step of the receiver transmitting category information concerning a function of the receiver; a second step of the transmitter receiving the category information; a third step of the transmitter selecting an interleaving scheme based on the category information received; a fourth step of the transmitter generating a control signal including information indicative of the interleaving scheme selected at the third step and multiplexing the control signal and the interleaved signals; a fifth step of the transmitter performing interleaving based on the interleaving scheme selected to generate the interleaved signals; a sixth step of the receiver demodulating the control signal multiplexed into the interleaved signals received and extracting the interleaving scheme; and a seventh step of the receiver deinterleaving the interleaved signals received based on the interleaving scheme extracted at the sixth step.

### Effects of the Invention

According to the present invention, an interleaving scheme is selected based on the category information so as to be suited to a category specified by the category information, achieving excellent reception performance.

### BRIEF DESCRIPTION OF THE DRAWINGS

FIG. 1 is a schematic block diagram illustrating the configuration of a transmission-and-reception system for MC-CDM wireless communication according to a first embodiment of the present invention.
FIG. 2 is a schematic block diagram illustrating the configuration of a transmission-and-reception apparatus 100 included in a base station 10 according to the first embodiment.
FIG. 3 is a schematic block diagram illustrating the configuration of a transmission-and-reception apparatus 200 included in mobile stations 2 to 4 respectively belonging to categories 2 to 4 according to the first embodiment.
FIG. 4 is a schematic block diagram illustrating the configuration of a transmission-and-reception apparatus 230 included in a mobile station 1 belonging to a category 1 according to the first embodiment.
FIG. 5 illustrates an example of a frame generated by a transmission frame generator 234 according to the first embodiment.
FIG. 6 is a sequence chart illustrating an example of a flow indicative of operations between the base station and the mobile station according to the first embodiment.
FIG. 7A illustrates an example of items stored in a storage 109 according to the first embodiment.
FIG. 7B illustrates another example of items stored in the storage 109 according to the first embodiment.
FIG. 7C illustrates still another example of items stored in the storage 109 according to the first embodiment.
FIG. 8 is a schematic block diagram illustrating the configuration of a transmission-and-reception system for MC-CDM wireless communication according to a second embodiment of the present invention.
FIG. 9 is a schematic block diagram illustrating the configuration of a transmission-and-reception apparatus 130 included in a base station 11 according to the second embodiment.
FIG. 10 is a schematic block diagram illustrating the configuration of a transmission-and-reception apparatus 260 included in a mobile station 6 according to the second embodiment.
FIG. 11 is a schematic block diagram illustrating the configuration of a transmission-and-reception apparatus 290 included in a mobile station 5 according to the second embodiment.
FIG 12 is a sequence chart illustrating an example of a flow indicative of operations between the base station 11 and the mobile stations 5 and 6 according to the second embodiment.
FIG. 13A illustrates an example of items stored in a storage 139 according to the second embodiment.
FIG. 13B illustrates another example of items stored in the storage 139 according to the second embodiment.
FIG. 14 is a graph illustrating an example of PER characteristics based on differences in interleaving schemes according to the second embodiment.
FIG. 15 is a schematic block diagram illustrating the configuration of a transmission-and-reception apparatus 300 included in a mobile station according to a third embodiment of the present invention.
FIG. 16 is a schematic block diagram illustrating the configuration of a transmission-and-reception apparatus 400 included in a base station according to the third embodiment.
FIG. 17 is a sequence chart illustrating an example of a flow indicative of operations between the base station and the mobile station according to the third embodiment.
FIG. 18 is a schematic block diagram illustrating the configuration of a transmission-and-reception apparatus 1500 according to a fourth embodiment of the present invention.
FIG. 19 is a schematic block diagram illustrating the configuration of a transmission-and-reception apparatus 1600 included in a mobile station that selects chip interleaving (third interleaver 258) according to the fourth embodiment.
FIG. 20 is a schematic block diagram illustrating the inner configuration of an interference signal canceller 1659 according to the fourth embodiment.
FIG. 21 is a schematic block diagram illustrating the configuration of a transmission-and-reception apparatus 1601 included in a mobile station that selects symbol interleaving (second interleaver 122) according to the fourth embodiment.
FIG. 22 is a schematic block diagram illustrating the inner configuration of an interference signal canceller 1660 according to the fourth embodiment.
FIG. 23A illustrates an example of items stored in a storage 1509 according to the fourth embodiment.
FIG. 23B illustrates another example of items stored in the storage 1509 according to the fourth embodiment.
FIG. 24 is a sequence chart illustrating a flow indicative of operations between the base station and the mobile station according to the fourth embodiment.
FIG. 25 is a graph illustrating an example of PER characteristics based on a combination of the repetition number of the interference signal canceller and interleaving schemes according to the fourth embodiment.
FIG. 26 is a schematic block diagram illustrating the configuration of a transmission-and-reception apparatus 1800 included in a base station according to a fifth embodiment of the present invention.
FIG. 27A illustrates an example of items stored in a storage 1809 according to the fifth embodiment.
FIG. 27B illustrates another example of items stored in the storage 1809 according to the fifth embodiment.
FIG. 28 is a graph illustrating an example of PER characteristics of the interference signal canceller 1660 according to the fourth embodiment.
FIG. 29A illustrates an example signal input to a third interleaver 126 according to the first embodiment.
FIG. 29B illustrates an example of a rearrangement performed by the third interleaver 126 according to the first embodiment.

### Description of Reference Symbols

1, 2, 3, 4, 5, and 6 mobile station
10 and 11 base station
100, 130, 200, 230, 260, 290, 300, 400, 1500, 1600, 1601, and 1800 transmission-and-reception apparatus
101 and 201 antenna
102 and 202 radio frequency converter
103, 133, 205, 235, 265, and 295 receiver
104 and 209 channel estimator
105 and 135 reception signal restorer
106, 136, 203, 233, 263, 293, 410, and 1633 transmitter
107 transmission parameter setter
108, 138, and 1508 interleave selector
109, 139, 1509, and 1809 storage
110-1 to 110-n, 214-1 to 214-n, 244-1 to 244-n, 274-1 to 274-n, and 294-1 to 294-n code-channel signal processor
111 and 1702 signal multiplexer
112 IFFT unit
113 parallel-to-serial conversion
114 GI adder
115 filter
116 D/A converter
117 information-data generator
118 and 1711 error correction encoder
119 first interleaver
120 and 1712 modulator
121, 211, and 1713 serial-to-parallel converter
122 and 1721 second interleaver
123 and 215 spreading code generator
124-1 to 124-m, and 1714-1 to 1714-m symbol copier
125-1-1 to 125-m-1, 216-1-1 to 216-m-1, and 1715-1-1 to 1715-m-1 multiplier
126 and 1716 third interleaver
204, 234, 264, 284, and 1634 transmission frame generator
206 A/D converter
207 filter
208 GI remover
210 weighting coefficient setter
212 FFT unit
213 channel compensator
217-1 to 217-m symbol multiplexer
218, 289, 302, and 1618 second deinterleaver
219 parallel-to-serial converter
220 demodulator
221 error correction decoder
258 and 303 third deinterleaver
259, 1659, and 1660 interference signal canceller
288 and 301 first deinterleaver
310 control-signal restorer
401 control-signal generation multiplexer
1701-1 to 1701-n, and 1730-1 to 1730-n code-channel replica generator
1703 channel variation multiplier
1704-1 to 1704-ml subtractor

### BEST MODE FOR CARRYING OUT THE INVENTION

### [First Embodiment]

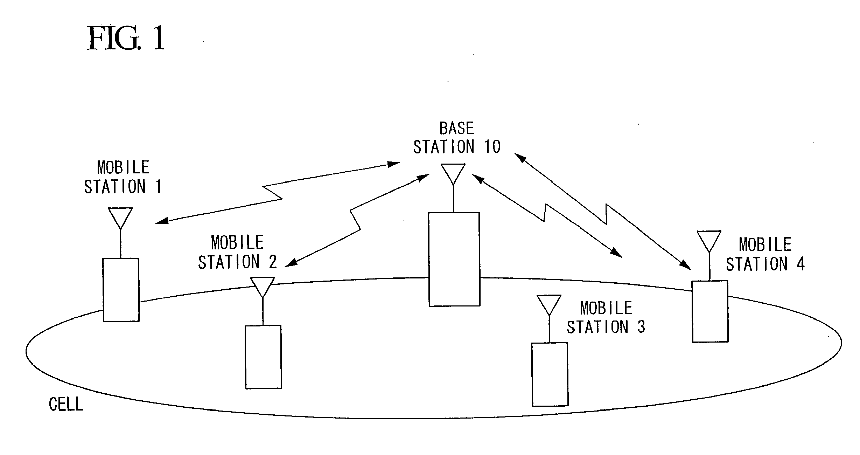

Hereinafter, exemplary embodiments of the present invention are explained with reference to accompanying drawings. FIG. 1 is a schematic block diagram illustrating the configuration of a transmission-and-reception system for MC-CDM wireless communication according to a first embodiment of the present invention. Mobile stations 1 to 4 are present in a cell served by a base station 10. The mobile stations 1 to 4 belong to respective categories (grades).

The base station 10 receives category information indicative of a category to which each of the mobile stations 1 to 4 belongs from each of the mobile stations 1 to 4. Based on the received category information, the base station 10 selects an interleaving scheme for information data to be transmitted to each of the mobile stations 1 to 4. Then, the base station 10 interleaves the information data with the selected interleaving scheme and transmits signals. The mobile stations 1 to 4 are categorized based on, for example, the types of terminals, such as audio dedicated terminals, video-phone dedicated terminals, or MBMS (Multimedia Broadcast/Multicast Service) terminals. Alternatively, the mobile stations 1 to 4 may be categorized based on the types of data, such as audio data, moving picture data, or packet data. Alternatively, the mobile stations 1 to 4 may be categorized based on services, QoS (Quality of Service), the level of modulation that can be demodulated by mobile stations, frequency bands or frequency bandwidths in which the mobile stations can perform communication.

Reception characteristics required for the mobile stations 1 to 4 categorized based on the above criteria differ. When the mobile stations are categorized based on the modulation level, for example, a mobile station capable of modulation of a high modulation level, such as 64 QAM, requires high SINR (Signal to Interference plus Noise power Ratio). Therefore, a transmission-and-reception apparatus on a receiving side has to perform interference cancelling as performed by an interference canceller.

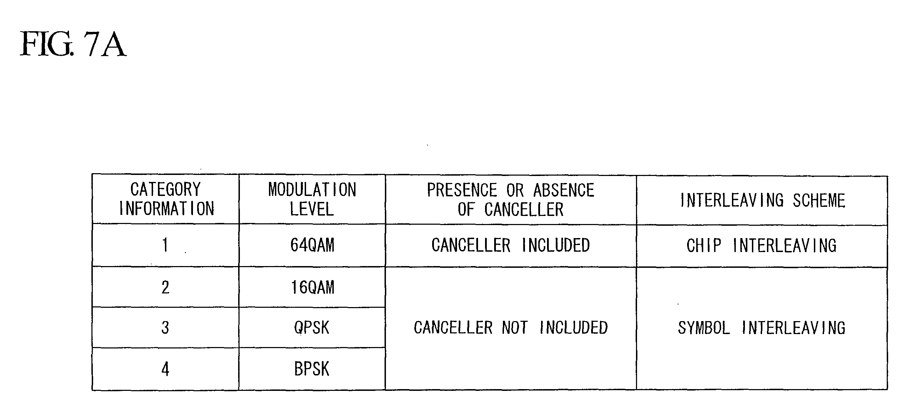

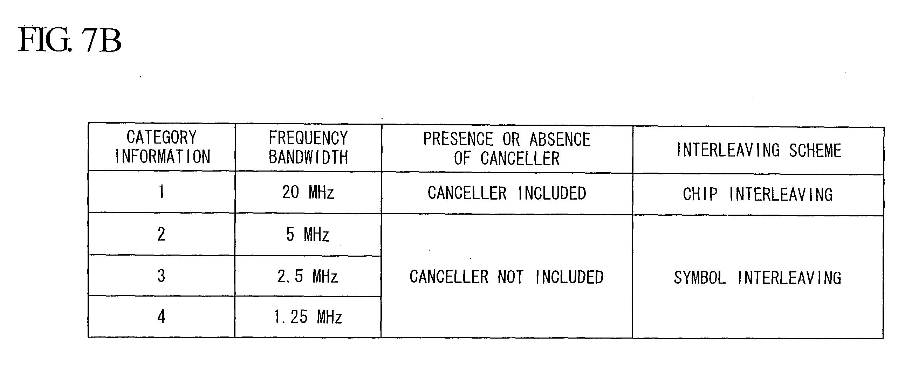

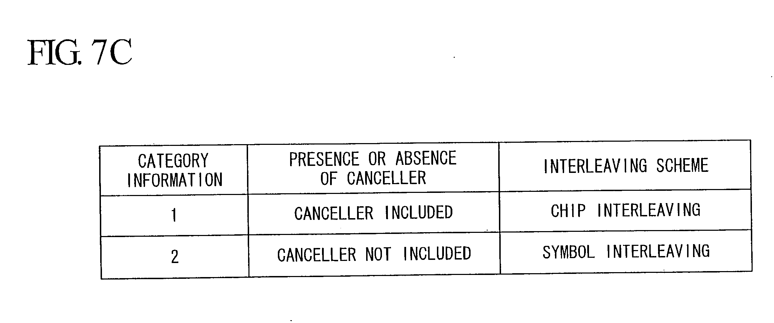

FIGS. 7A to 7C illustrate examples of the categorization. FIG. 7A illustrates a table indicative of interleaving schemes to be selected for respective categories when the categorization is carried out based on the modulation level. The category information "1" corresponds to the modulation level of "64 QAM", "canceller included", and the interleaving scheme of "chip interleaving". The category information "2" corresponds to the modulation level of "16 QAM", "canceller not included", and the interleaving scheme of "symbol interleaving". The category information "3" corresponds to the modulation level of "QPSK", "canceller not included", and the interleaving scheme of "symbol interleaving". The category information "4" corresponds to the modulation level of "BPSK", "canceller not included", and the interleaving scheme of "symbol interleaving". FIG. 7B illustrates a table indicative of interleaving schemes to be selected for respective categories when the categorization is carried out based on frequency bands in use. The table stores frequency bandwidths of "20 MHz", "5 MHz", "2.5 MHz", and "1.25 MHz" corresponding to the category information "1" to "4". The table shown in FIG. 7B stores information concerning presence or absence of a canceller, and interleaving schemes, similarly to that shown in FIG. 7A. FIG. 7C illustrates an example of a table when the categorization is carried out based on presence or absence of an interference canceller. The category information "1" corresponds to "canceller included" and the interleaving scheme of "chip interleaving". The category information "2" corresponds to "canceller not included" and the interleaving scheme of "symbol interleaving".

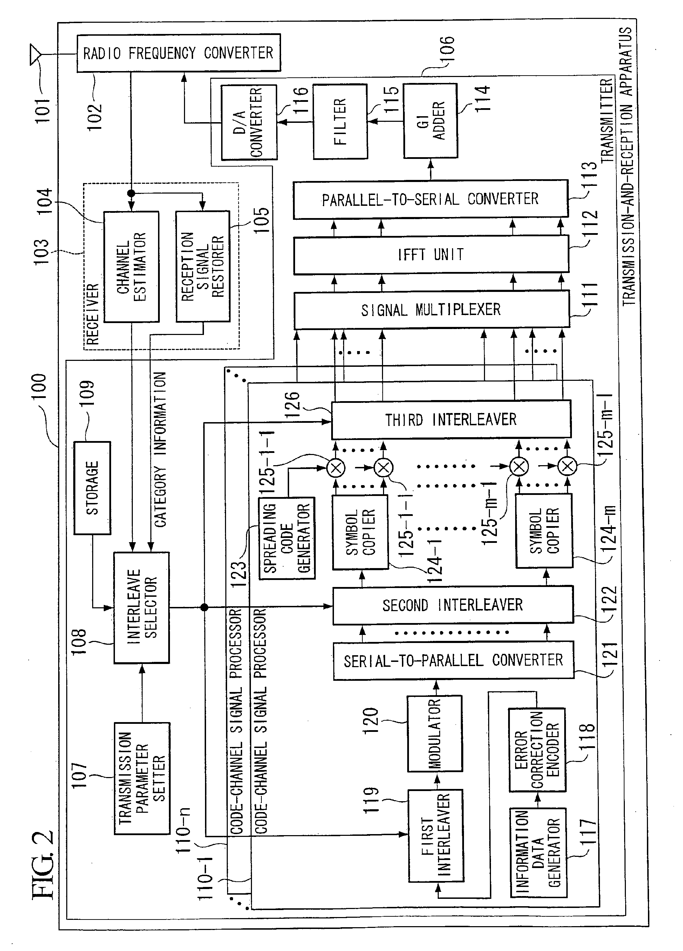

FIG. 2 is a schematic block diagram illustrating the configuration of a transmission-and-reception apparatus 100 included in the base station 10. An antenna 101 receives signals transmitted from the mobile stations 1 to 4, or transmits signals generated by the transmission-and-reception apparatus 100. A radio frequency converter 102 converts the signals received from the mobile stations 1 to 4 through the antenna 101 into restorable frequency band signals, or converts signals to be transmitted into transmittable frequency band signals. A receiver 103 includes a channel estimator 104 and a reception signal restorer 105. The channel estimator 104 estimates a channel through which the reception signal has been transmitted based on a control channel, a preamble, a pilot signal, and the like, which are included in the reception signals. An estimation result includes a delay profile, delay spread characteristics, the maximum Doppler frequency, and the like, which are caused by multipath fading. The reception signal restorer 105 performs reception-signal restoring processing, such as data demodulation and error correction decoding, on the signals received from the mobile stations 1 to 4 to obtain category information included therein.

A transmitter 106 that generates transmission signals includes a transmission parameter setter 107, an interleave selector 108, a storage 109, code-channel signal processors 110-1 to 110-n, a signal multiplexer 111, an IFFT (Inverse Fast Fourier Transform) unit 112, a parallel-to-serial converter 113, a GI (Guard Interval) adder 114, a filter 115, and a D/A (Digital to Analogue) converter 116.

The transmission parameter setter 107 sets, to the transmission-and-reception apparatus 100, the modulation level for signals to be transmitted, such as QPSK or 16 QAM, the code multiplexing number, spreading factors, and the like. Referring to the storage 109, the interleave selector 108 selects an interleaving scheme to be applied to transmission signals based on the category information obtained by the reception signal restorer 105 and instructs interleaving based on the selected scheme. The interleave selector 108 may select an interleaving scheme to be applied based on at least one of a channel estimation value estimated by the channel estimator 104 and a transmission signal parameter.
The storage 109 stores assignment information concerning interleaving schemes based on at least one of the category information, a channel estimation value estimated by the channel estimator 104, and a transmission signal parameter. The storage 109 stores information as tables shown in FIGS. 7A to 7C. The storage 109 stores information concerning categories, items to be criteria for selecting interleaving schemes corresponding to respective categories, and interleaving schemes to be assigned, which are correlated to one another. However, the storage 109 may store only the category information and the interleaving scheme information determined based on the information concerning the items to be selection criteria, which are correlated to each other. The category information includes the types of terminals, the types of data, services, QoS, the modulation level, frequency bands, frequency bandwidths, or the like, which are explained above. In this case, the storage 109 stores interleaving scheme information corresponding to the category information.

The code-channel signal processors 110-1 to 110-n generate channel signals to be code-multiplexed. Reference symbol n denotes the maximum code multiplexing number. The signal multiplexer 111 code-multiplexes the channel signals generated by the code-channel signal processors. The IFFT unit 112 converts the signals output from the signal multiplexer 111 that are frequency domain signals into time domain signals. The parallel-to-serial converter 113 converts the signals output from the IFFT unit 112 that are parallel signals into a serial signal. The GI adder 114 adds a guard interval to the signals output from the parallel-to-serial converter 113. The filter 115 extracts a signal of a desired band from signals output from the GI adder 114. The D/A converter 116 converts a digital signal output from the filter 115 into an analog signal.

Each of the code-channel signal processors 110-1 to 110-n includes an information data generator 117, an error correction encoder 118, a first interleaver 119, a modulator 120, a serial-to-parallel converter 121, a second interleaver 122, a spreading code generator 123, symbol copiers 124-1 to 124-m, and multipliers 125-1-1 to 125-m-1. The information data generator 117 generates information data to be transmitted. The error correction encoder 118 performs error correction coding, such as turbo coding or convolutional coding on the information data generated by the information data generator 117. Errors that have occurred on a channel can be detected and corrected using the information concerning the coding upon decoding on a receiving side. The first interleaver 119 interleaves data output from the error correction encoder 118 upon receiving an interleaving instruction from the interleave selector 108. The first interleaver 119 outputs data output from the error correction encoder 118 as is if an interleaving instruction is not received. The interleaving scheme used by the first interleaver 119 is bit interleaving.

The modulator 120 performs data modulation, such as QPSK or 16 QAM, on data output from the first interleaver 119 to generate symbols. The modulator 120 performs data modulation on a signal subjected to error correction coding to generate symbols when the first interleaving is not performed. The serial-to-parallel converter 121 converts a serial signal string of symbols modulated by the modulator 120 into a parallel signal strings. The second interleaver 122 interleaves the parallel signal strings of the symbols converted by the serial-to-parallel converter 121 upon receiving an interleaving instruction from the interleave selector 108. The second interleaver 122 outputs the parallel signal strings of the symbols converted by the serial-to-parallel converter 121 as are if an interleaving instruction is not received. The interleaving scheme used by the second interleaver 122 is symbol interleaving. The spreading code generator 123 generates a spreading code string to be used for spreading of code channels corresponding to the code-channel signal processors, such as OVSF (Orthogonal Variable Spreading Factor) codes.

According to the length or cycle of the spreading code string generated by the spreading code generator 123, the symbol copiers 124-1 to 124-m copy signals output from the second interleaver 122 to generate signals of symbols corresponding to respective chips where m is the number of symbols to be arranged in the frequency direction. When the second interleaving is not performed, the symbol copiers 124-1 to 124-m copy symbols output through the modulator 120 and the serial-to-parallel converter 121. The multipliers 125-1-1 to 125-m-1 multiply outputs of the symbol copiers 124-1 to 124-m by the spreading codes generated by the spreading code generator 123 to perform code spreading where 1 is equal to a spreading factor of the spreading codes output by the spreading code generator 123.
The third interleaver 126 interleaves the spread signals of each chip that are output from the multipliers 125-1-1 to 125-m-1 when an interleaving instruction is received from the interleave selector 108. The interleaving scheme used by the third interleaver 126 is chip interleaving. In the first embodiment, the first to third interleavers 119, 122, and 126 function as an interleaver. Additionally, the multipliers 125-1-1 to 125-m-1 and the signal multiplexer 111 function as a code multiplexer.
Hereinafter, the first to third interleavers 119, 122, and 126 are further explained.
The third interleaver (chip interleaver) 126 interleaves signals output from the multipliers 125-1-1 to 125-m-1 based on a pattern and outputs the interleaved signals.

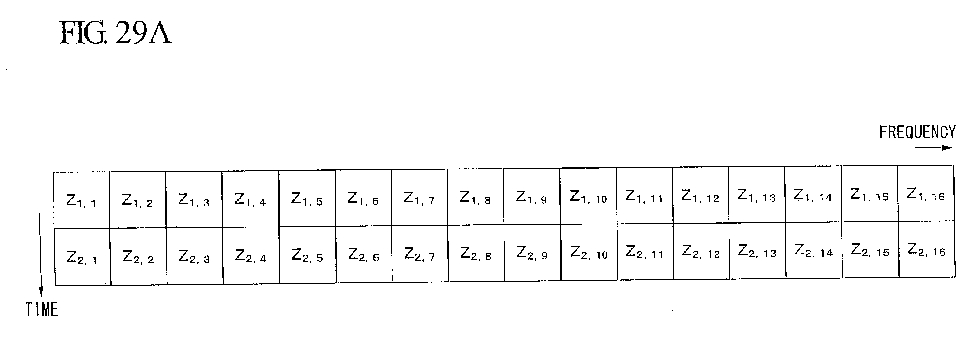

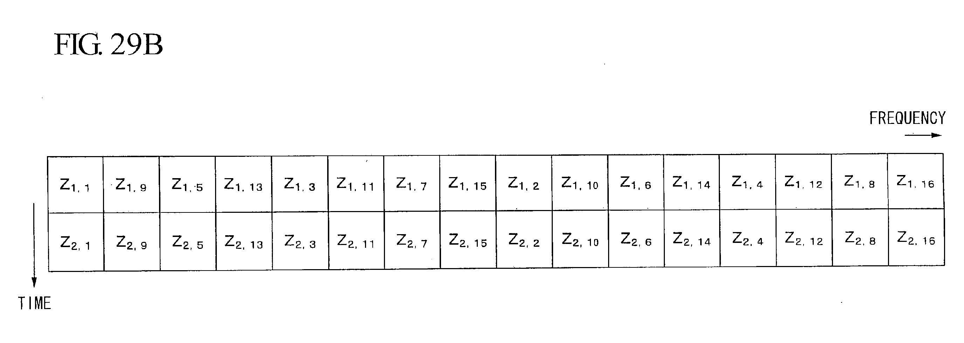

FIGS. 29A and 29B illustrate examples of interleaving performed by the third interleaver 126. This interleaving pattern is an example when "3GPP, TS25,212 V5.1.0 'Multiplexing and channel coding (FDD)"' is applied thereto. The horizontal and vertical axes respectively represent frequency and time. The case of a transmission-and-reception apparatus that transmits two MC-CDM symbols, where the number of MC-CDM subcarriers Nc=16, the spreading factor SF=4 (the symbol copier generates four copies), i.e., the case of FIG. 2 where 1=4 and m=4, is shown. Z_{1, 1} to Z₁, ₁₆ denote signals that are output from the multipliers 125-1-1 to 125-m-1 and assigned to subcarriers for the first MC-CDM symbol. Z_{2, 1} to Z_{2, 16} denote signals that are output from the multipliers 125-1-1 to 125-m-1 and assigned to subcarriers for the second MC-CDM symbol.

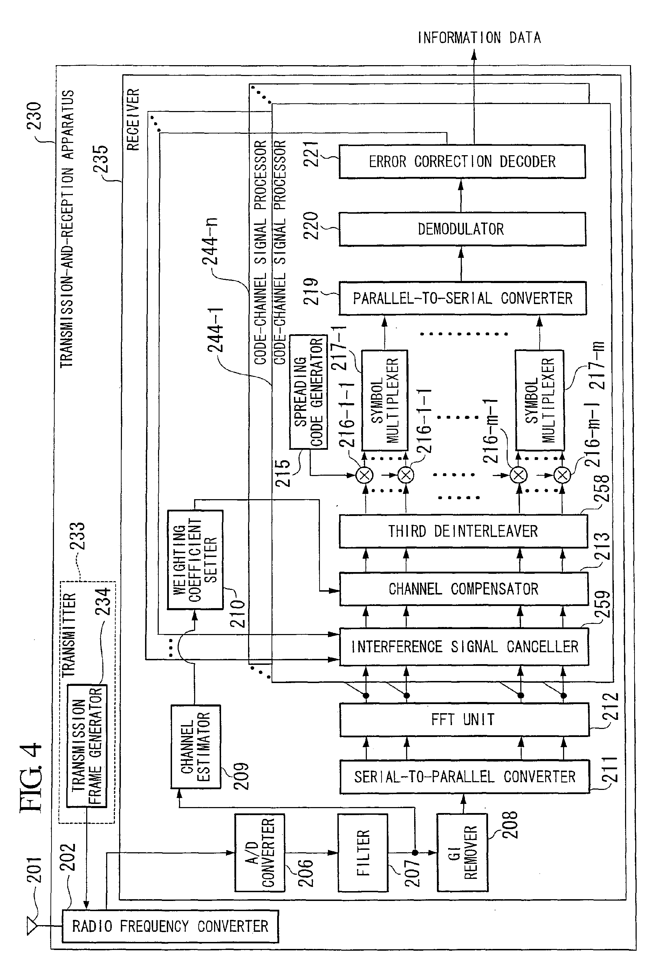

FIG. 29A shows signals to be input to the third interleaver 126. FIG. 29B illustrates an example of the output signals shown in FIG. 29A that are interleaved in the frequency direction where the interleave size is Nc. Although the same interleave pattern is used for the first and second MC-CDM symbols, different interleave patterns may be used. A third deinterleaver 258 included in a transmission-and-reception apparatus shown in FIG. 4 (the details will be explained later) that receives the signals transmitted from the transmission-and-reception apparatus shown in FIG. 2 deinterleaves the received signals so that the arrangement of FIG. 29B is changed back to that of FIG. 29A.
The second interleaver (symbol interleaver) 122 interleaves the modulated signals output from the serial-to-parallel converter 121 based on a pattern and outputs the interleaved signals. This is enabled by the second interleaver 122 arranging signals to be assigned (input) to the symbol copiers 124-1 to 124-m in the frequency direction shown in FIG. 29A and then rearranging the signals similarly to the case of FIG. 29B. In this case, the interleave size (the number of signals arranged in the frequency direction) is Nc/SF which is smaller than the chip-interleave size. Similar to symbol interleaving, different interleave patterns may be used for the MC-CDM symbols.
The first interleaver (bit interleaver) 119 interleaves data output from the error correction encoder 118 based on a pattern shown in FIGS. 29A and 29B, and outputs the interleaved data. The interleave size is ω×Nc/SF (ω is the level of data modulation performed by the modulator 120, such as ω=2 in the case of QPSK, or ω=4 in the case of 16 QAM).
Hereinafter, chip interleaving, symbol interleaving, and bit interleaving of the embodiments are performed in a similar manner.

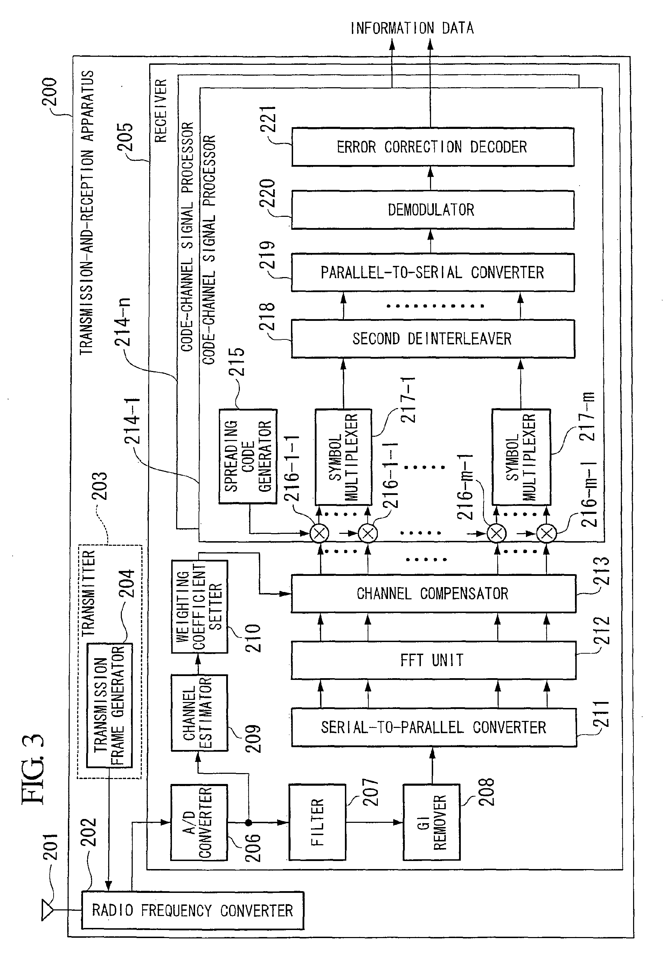

FIG 3 is a schematic block diagram illustrating the configuration of a transmission-and-reception apparatus 200 included in each of the mobile stations 2 to 4 respectively belonging to categories 2 to 4. An antenna 201 receives signals transmitted from the base station 10, or transmits signals generated by the transmission-and-reception apparatus 200. A radio frequency converter 202 performs frequency conversion of signals received from the base station 10 through the antenna 201 into baseband signals. Additionally, the radio frequency converter 202 converts signals generated by the transmission-and-reception apparatus 200 into transmittable frequency band signals. A transmitter 203 includes a transmission frame generator 204 and can output signals based on a wireless communication system, such as an MC-CDM system, an OFDM system, a CDMA system, or a single-carrier modulation system, as long as a communication destination can restore data of an information channel and a control channel including interference canceller information.

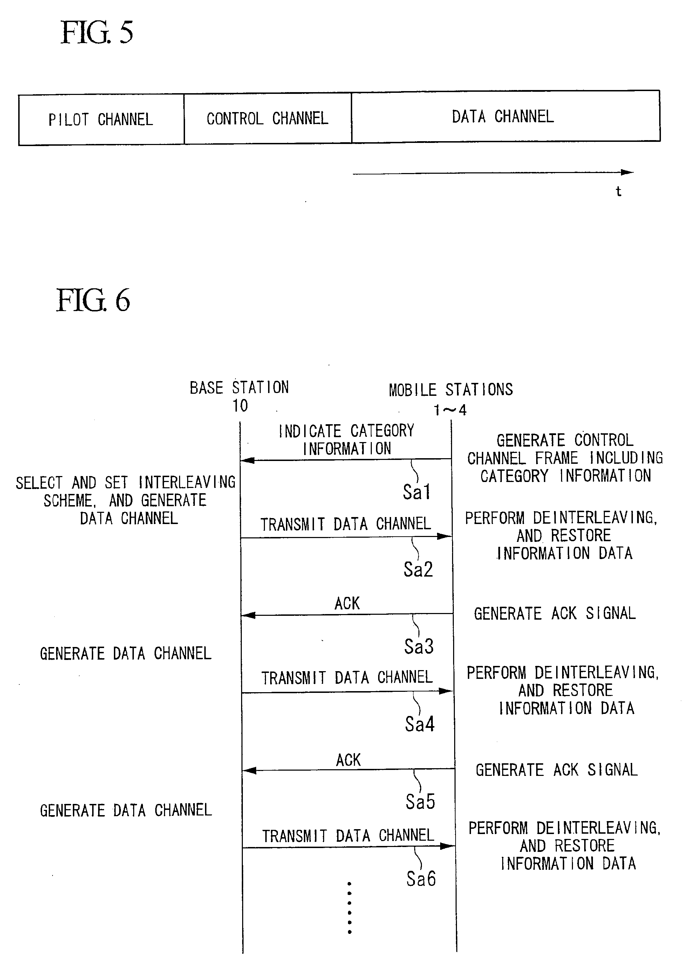

The transmission frame generator 204 generates data to be transmitted, such as information data to be transmitted by the transmission-and-reception apparatus 200 or control data including category information, and performs any of error correction coding, data modulation, spreading processing, and the like, and arranges the processed data on a frame. Since the mobile stations 2 to 4 respectively belong to categories 2 to 4, the transmission frame generator 204 included in each of the mobile stations 2 to 4 generates control data including category information indicative of the category to which each of the mobile stations belongs among the categories 2 to 4. FIG. 5 illustrates an example of data generated by the transmission frame generator 204. FIG. 5 shows a frame format in the case where signal processing, such as error correction coding, data modulation, and spreading, is performed on information data and control data that includes interference canceller information, and then a pilot channel to be used for channel estimation and the like, a control channel including control data such as category information, and a data channel including information data are time-multiplexed. FIG. 5 shows only an example, and the format in the case where those channels are frequency-multiplexed or code-multiplexed may be used. Further, the transmission frame generator 204 generates an ACK (Acknowledge) signal for requesting information data to the base station 10.

With reference to FIG. 3, a reference numeral 205 represents a receiver that extracts information data from the baseband signals output from the radio frequency converter 202. The receiver 205 includes an A/D converter 206, a filter 207, a GI remover 208, a channel estimator 209, a weighting coefficient setter 210, a serial-to-parallel converter 211, an FFT (Fast Fourier Transform) unit 212, a channel compensator 213, and code-channel signal processors 214-1 to 214-n. The A/D converter 206 converts an analog signal output from the radio frequency converter 202 into a digital signal. The filter 207 extracts a signal of a desired band from signals output from the A/D converter 206. The GI remover 208 removes, from the signal output from the filter 207, a guard interval GI added by the transmission-and-reception apparatus 100 included in the base station 10 to prevent distortion caused by delayed waves.

The channel estimator 209 estimates a channel through which the received signal has been transmitted based on a control channel (reception information), a preamble, a pilot signal, and the like, which are included in the received signal. An estimation result includes a delay profile, delay spread characteristics, the maximum Doppler frequency, and the like, which are caused by multipath fading. The weighting coefficient setter 210 calculates a weighting coefficient for correcting channel distortion using, for example, MMSE (Minimum Mean Square Error) or MRC (Maximum Ratio Combing) based on a signal output from the channel estimator 209.

The serial-to-parallel converter 211 performs serial-to-parallel conversion on a signal output from the GI remover 208. The FFT unit 212 performs Fourier transform to covert time domain signals output from the serial-to-parallel converter 211 into frequency signals. The channel compensator 213 multiplies signals output from the FFT unit 212 by a signal output from the weighting coefficient setter 210 to compensate channel distortion caused by, for example, fading. The code-channel signal processors 214-1 to 214-n perform signal processing on signals output from the channel compensator 213 for respective channel signals that are code-multiplexed, and output information data. Each of the code-channel signal processors 214-1 to 214-n includes a spreading code generator 215, multipliers 216-1-1 to 216-m-1, symbol multiplexers 217-1 to 217-m, a second deinterleaver 218, a parallel-to-serial converter 219, a demodulator 220, and an error correction decoder 221.

The spreading code generator 215 generates given inverse-spreading codes for the respective code-channel signal processors 214-1 to 214-m. The multipliers 216-1-1 to 216-m-1 multiply subcarrier signals by the spreading codes generated by the spreading code generator 215 to perform inverse spreading. Each of the symbol multiplexers 217-1 to 217-m multiplexes the given number of the inversely spread signal strings into one signal. The second deinterleaver 218 deinterleaves the signals output from the symbol multiplexers 217-1 to 217-m using a reverse pattern of the interleave pattern used by the second interleaver 122 (shown in FIG. 2). The parallel-to-serial converter 219 converts the parallel signal strings deinterleaved by the second deinterleaver into a serial signal string. The demodulator 220 performs demodulation, such as QPSK or 16 QAM, on the signal output from the parallel-to-serial converter 219. The error correction decoder 221 performs error correction decoding on the signal output from the demodulator 220 to obtain information data. The decoding performed by the demodulator 220 may be soft decision decoding or hard decision decoding. In the first embodiment, the multipliers 216-1-1 to 216-m-1 and the symbol multiplexers 217-1 to 217-m function as a code demultiplexer.

FIG. 4 is a schematic block diagram illustrating the configuration of a transmission-and-reception apparatus 230 included in the mobile station 1 belonging to category 1. The antenna 201 receives signals transmitted from the base station 10, or transmits signals generated by the transmission-and-reception apparatus 230. The radio frequency converter 202 performs frequency conversion of signals received from the base station 10 through the antenna 201 into baseband signals. Additionally, the radio frequency converter 202 converts signals generated by the transmission-and-reception apparatus 230 into transmittable frequency band signals. A transmitter 233 includes a transmission frame generator 234 and generates signals to be transmitted. These signals may be output based on a wireless communication system, such as an MC-CDM system, an OFDM system, a CDMA system, or a single-carrier modulation system, as long as a communication destination can restore transmitted data.

The transmission frame generator 234 generates data to be transmitted, such as information data to be transmitted by the transmission-and-reception apparatus 230 or control data including category information indicative of the category 1 to which the mobile station 1 belongs, performs signal processing, such as error correction coding, data modulation, and the like, and then arranges the processed data on a frame. FIG. 5 illustrates an example of data generated by the transmission frame generator 234. FIG. 5 shows a frame format in the case where signal processing, such as error correction coding, data modulation, or spreading, is performed on information data and control data that includes the category information, and then a pilot channel to be used for channel estimation and the like, a control channel including control data such as category information, and a data channel including information data are time-multiplexed. FIG. 5 shows only an example, and a format in the case where those channels are frequency-multiplexed or code-multiplexed may be used.

A receiver 235 extracts information data from the baseband signals output from the radio frequency converter 202. The receiver 235 includes the A/D converter 206, the filter 207, the GI remover 208, the channel estimator 209, the weighting coefficient setter 210, the serial-to-parallel converter 211, the FFT unit 212, and code-channel signal processors 244-1 to 244-n. The A/D converter 206 converts an analog signal output from the radio frequency converter 202 into a digital signal. The filter 207 extracts a signal of a desired band from signals output from the A/D converter 206.
The GI remover 208 removes, from signals output from the filter 207, a guard interval GI added by the base station 10 to prevent distortion caused by delayed waves.

The channel estimator 209 estimates a channel through which the received signal has been transmitted based on a control channel, a preamble, a pilot signal, and the like, which are included in the received signal. An estimation result includes a delay profile, delay spread characteristics, the maximum Doppler frequency, and the like, which are caused by multipath fading. The weighting coefficient setter 210 calculates a weighting coefficient for correcting channel distortion using, for example, MMSE (Minimum Mean Square Error) or MRC (Maximum Ratio Combing) based on signals output from the channel estimator 209.

The serial-to-parallel converter 211 performs serial-to-parallel conversion on a signal output from the GI remover 208. The FFT unit 212 performs Fourier transform to covert time domain signals output from the serial-to-parallel converter 211 into frequency signals. The code-channel signal processors 244-1 to 244-n perform signal processing on signals output from the FFT unit 212 for respective channel signals that are code-multiplexed, and output information data. Each of the code-channel signal processors 244-1 to 244-n includes an interference signal canceller 259, the channel compensator 213, a third deinterleaver 258, the spreading code generator 215, the multipliers 216-1-1 to 216-m-1, the symbol multiplexers 217-1 to 217-m, the parallel-to-serial converter 219, the demodulator 220, and the error correction decoder 221.

The interference signal canceller 259 generates replicas of the non-desired signals causing multi-code interference MCI based on a soft decision result (or log likelihood) or a hard decision result which is input from the error correction decoder 221, and cancels the replicas of the non-desired signals from signals output from the FFT unit 212. The channel compensator 213 multiplies signals output from the interference signal canceller 259 by a signal output from the weighting coefficient setter 210 to compensate channel distortion caused by, for example, fading.

The third deinterleaver 258 performs the inverse of the operation performed by the third interleaver 126 included in the base station 10. In other words, the third deinterleaver 258 performs deinterleaving by rearranging signals output from the channel compensator 213 using a reverse pattern of the interleave pattern used by the third interleaver 126. The spreading code generator 215 generates given inverse-spreading codes for the respective code-channel signal processors. The multipliers 216-1-1 to 216-m-1 multiply subcarrier signals by the spreading codes generated by the spreading code generator to perform inverse spreading.

Each of the symbol multiplexers 217-1 to 217-m multiplexes the given number of the inversely spread signal strings into one signal string. The parallel-to-serial converter 219 converts the parallel signal strings output from the symbol multiplexers 217-1 to 217-m into a serial signal string. The demodulator 220 performs demodulation, such as QPSK or 16 QAM, on the signal output from the parallel-to-serial converter 219. The error correction decoder 221 performs error correction decoding on the signal output from the demodulator 220 to obtain information data. The decoding by the error correction decoder 221 may be soft decision decoding or hard decision decoding. A signal output from the error correction decoding 221 is input to the interference signal canceller 259. In the first embodiment, the multipliers 216-1-1 to 216-m-1 and the symbol multiplexers 217-1 to 217-m function as a code demultiplexer.

FIG. 6 illustrates a flow of operations performed by the base station and the mobile stations. In the mobile stations 1 to 4, each of the transmission frame generators 204 and 234 generates a control channel frame including category information indicative of a category to which each of the mobile stations 1 to 4 belongs, and transmits the control channel frame to the base station 10 to indicate the category information (Sa1). Although the category information is indicated by the control channel, a signal indicative of control information, such as a pilot channel or a preamble, may be used instead. In the base station 10, the reception signal restorer 105 obtains the category information included in the received control channel. Then, the interleave selector 108 selects an interleaving scheme corresponding to the category information referring to the storage 109. Then, a corresponding unit of the first to third interleavers 119, 122, and 126 performs interleaving based on the selected interleaving scheme. Thereby, a data channel to be transmitted to the mobile station that has transmitted the category information is generated. Then, the data channel is transmitted to the mobile stations (Sa2). If the storage 109 stores the table shown in FIG. 7A and the category 1 is indicated by the mobile station 1, chip interleaving (third interleaver 126) is selected. Thereby, the base station 10 generates a data channel subjected to chip interleaving by the third interleaver 126.

A transmission target among the mobile station devices 1 to 4 receives the data channel, performs signal processing including deinterleaving based on the interleaving scheme used by the base station 10 to restore information data. If more information data is required, the transmission frame generator 204 or 234 of the mobile station generates an ACK signal and transmits the ACK signal to the base station 10 (Sa3). The ACK signal may or may not include the category information. If the ACK signal is received from the mobile station, the base station 10 generates a data channel signal interleaved with an interleaving scheme the same as the previous one, and transmits the data channel signal to the mobile station (Sa4). The same process from sequence Sa2 repeats from sequence Sa5 until all necessary information data is transmitted.

As explained above, the base station 10 selects an interleaving scheme based on category information reflecting the reception characteristics of the mobile station device 1 to 4 on the receiving side. Thereby, data interleaved with the interleaving scheme suited to the reception characteristics of the respective mobile stations 1 to 4 can be transmitted. Therefore, the reception performance of the mobile station devices 1 to 4 can maximally be enhanced.

### [Second Embodiment]

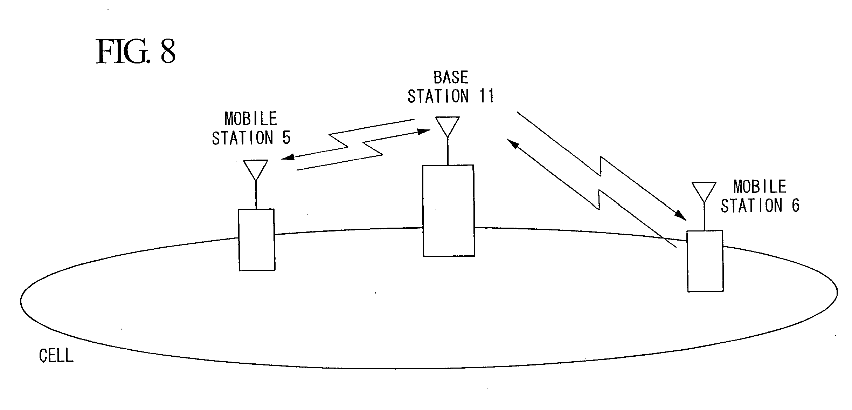

Hereinafter, a second embodiment of the present invention is explained in which an interleaving scheme is selected based on whether an interference canceller is included in a receiver of a transmission-and-reception apparatus included in a mobile station in a transmission-and-reception system for MC-CDM wireless communication. FIG. 8 is a schematic block diagram illustrating the configuration of a transmission-and-reception system for MC-CDM wireless communication according to the second embodiment. Mobile stations 5 and 6 are present in a cell served by a base station 11. The mobile stations 5 and 6 have transmission-and-reception apparatuses including receivers of different functions. The base station 11 receives interference canceller information from each of the mobile stations 5 and 6. Based on the interference canceller information, the base station 11 selects an interleaving scheme for information data to be transmitted to each of the mobile stations 5 and 6. Then, the base station 11 performs interleaving based on the selected interleaving scheme, and transmits the interleaved signals. The interference canceller information is one of the category information.

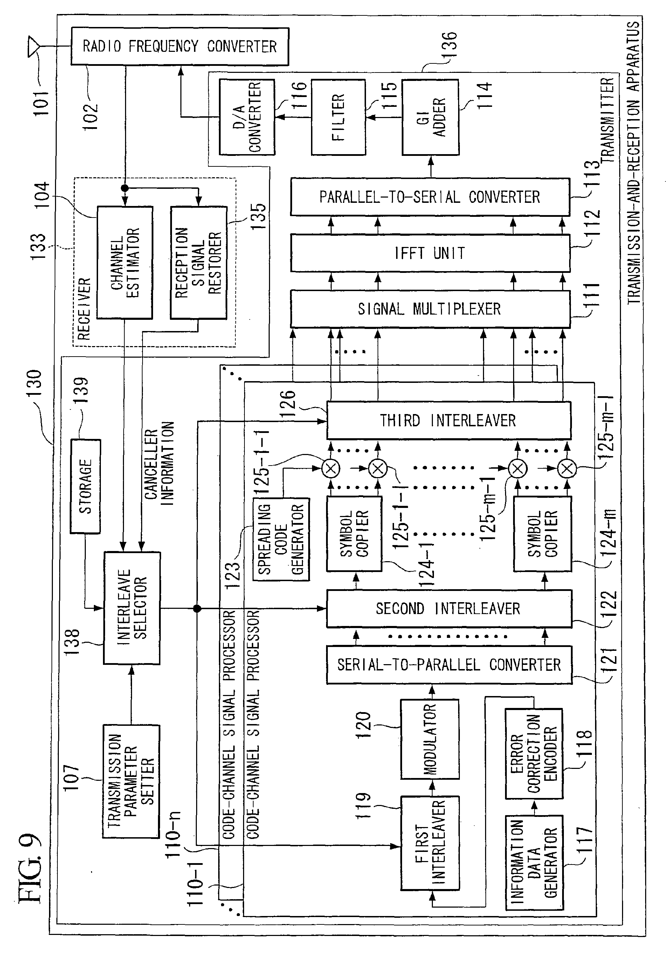

FIG. 9 is a schematic block diagram illustrating the configuration of a transmission-and-reception apparatus 130 included in the base station 11. The transmission-and-reception apparatus 130 shown in FIG. 9 includes the antenna 101, the radio frequency converter 102, a receiver 133, and a transmitter 136. The antenna 101 receives signals transmitted from the mobile stations 5 and 6, or transmits signals generated by the transmitter 136. The radio frequency converter 102 converts the signals received from the mobile stations 5 and 6 through the antenna 101 into restorable frequency band signals, or converts signals generated by the transmitter 136 into transmittable frequency band signals. The receiver 133 includes the channel estimator 104 and a reception signal restorer 135. The channel estimator 104 estimates a channel through which the reception signal has been transmitted based on a control channel, a preamble, a pilot signal, and the like, which are included in the reception signals. The result of the estimation performed by the channel estimator 104 includes a delay profile, delay spread characteristics, the maximum Doppler frequency, and the like, which are caused by multipath fading. The reception signal restorer 135 performs reception-signal restoring processing, such as data demodulation and decoding, on the signals received from the mobile stations 5 and 6 to obtain interference canceller information included therein.

The transmitter 136 includes the transmission parameter setter 107, the interleave selector 108, a storage 139, the code-channel signal processors 110-1 to 110-n, the signal multiplexer 111, the IFFT (Inverse Fast Fourier Transform) unit 112, the parallel-to-serial converter 113, the GI (Guard Interval) adder 114, the filter 115, and the D/A converter 116. The transmission parameter setter 107 sets, to the transmission-and-reception apparatus 130, the modulation level for signals to be transmitted, such as QPSK or 16 QAM, the code multiplexing number, spreading factors, and the like. Referring to the storage 139, the interleaver 138 selects an interleaving scheme to be applied to transmission signals based on the interference canceller information obtained by the reception signal restorer 135. The interleave selector 138 may select an interleaving scheme to be applied based on the interleaving canceller information and at least one of a channel estimation value estimated by the channel estimator 104 and a transmission signal parameter. The storage 139 stores assignment information concerning interleaving schemes based on at least one of interference canceller information, the interference canceller information and a channel estimation value estimated by the channel estimator 104 or a transmission signal parameter.

The signal multiplexer 111 code-multiplexes the channel signals generated by the code-channel signal processors 110-1 to 110-n. The IFFT unit 112 converts the frequency domain signals output from the signal multiplexer 111 into time domain signals. The parallel-to-serial converter 113 converts the parallel signals output from the IFFT unit 112 into a serial signal. The GI adder 114 adds a guard interval to the signals output from the parallel-to-serial converter 113. The filter 115 extracts a signal of a desired band from signals output from the GI adder 114. The D/A converter 116 converts a digital signal output from the filter 115 into an analog signal. Code-channel signal processors 110-1 to 110-n generate signals of respective channels to be code-multiplexed. Each of the code-channel signal processors 110-1 to 110-n includes the information data generator 117, the error correction encoder 118, the first interleaver 119, the modulator 120, the serial-to-parallel converter 121, the second interleaver 122, the spreading code generator 123, the symbol copiers 124-1 to 124-m, the multipliers 125-1-1 to 125-m-1, and a third interleaver 126.

The information data generator 117 generates information data to be transmitted. The error correction encoder 118 performs error correction coding, such as turbo coding or convolutional coding. Errors that have occurred on a channel can be detected and corrected using the information concerning the coding upon decoding on a receiving side. The first interleaver 119 interleaves data output from the error correction encoder 118. The interleaving scheme used by the first interleaver 119 is bit interleaving. The modulator 120 performs data modulation, such as QPSK or 16 QAM, on data output from the first interleaver 119. The modulator 120 performs data modulation on a signal subjected to error correction coding when the first interleaving is not performed.

The serial-to-parallel converter 121 converts a serial signal string output from the modulator 120 into parallel signal strings. The second interleaver 122 interleaves the modulated signals, which corresponds to symbol interleaving. The spreading code generator 123 generates a spreading code string, such as an OVSF code. The symbol copiers 124-1 to 124-m copy signals output from the second interleaver 122 according to the length or cycle of the spreading code string generated by the spreading code generator 123. When the second interleaving is not performed, the symbol copiers 124-1 to 124-m copy symbols supplied through the modulator 120 and the serial-to-parallel converter 121. The multipliers 125-1-1 to 125-m-1 multiply outputs of the symbol copiers 124-1 to 124-m by the spreading codes generated by the spreading code generator 123 to perform code spreading. The third interleaver 126 interleaves the spread signals output from the multipliers 125-1-1 to 125-m-1 when an interleaving instruction is received from the interleave selector 138.

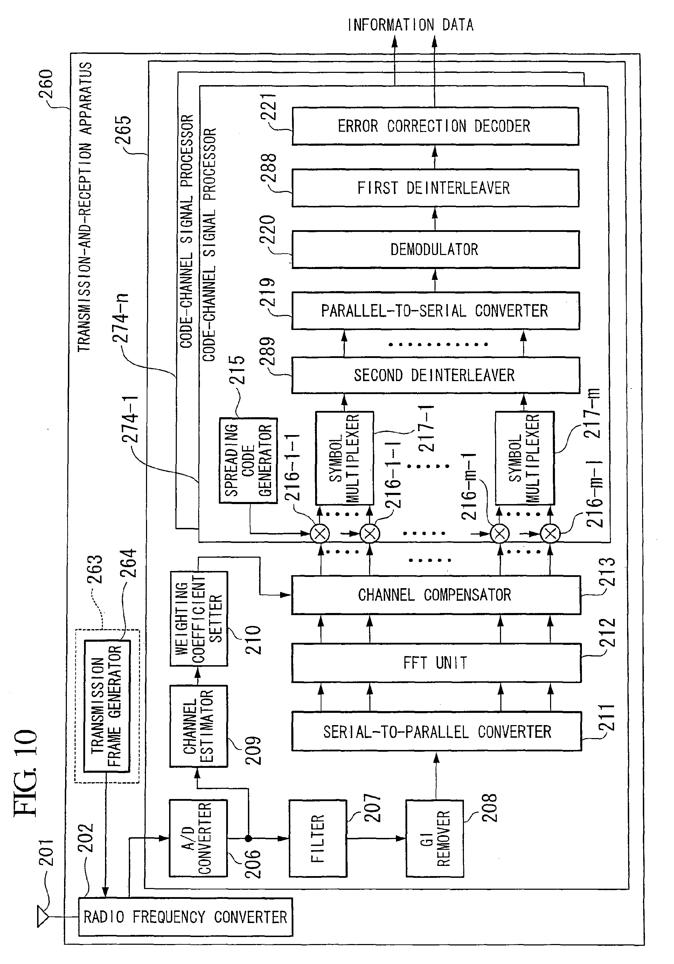

FIG. 10 is a schematic block diagram illustrating the configuration of a transmission-and-reception apparatus 260 included in the mobile station 6.
The antenna 201 receives signals transmitted from the base station 11, or transmits signals generated by the transmission-and-reception apparatus 260. The radio frequency converter 202 performs frequency conversion of signals received from the base station 11 through the antenna 201 into baseband signals. Additionally, the radio frequency converter 202 converts signals generated by the transmission-and-reception apparatus 260 into transmittable frequency band signals. A transmitter 263 includes a transmission frame generator 264. The transmitter 263 can output signals based on a wireless communication system, such as an MC-CDM system, an OFDM system, a CDMA system, or a single-carrier modulation system, as long as a communication destination can restore data of an information channel and a control channel including interference canceller information.

The transmission frame generator 264 generates data to be transmitted, such as information data to be transmitted by the mobile station 6 or control data including interference canceller information, and performs any of signal processing, such as error correction coding, data modulation, spreading processing, and the like, and arranges the processed data on a frame. FIG. 5 illustrates an example of data generated by the transmission frame generator 264. FIG. 5 shows a frame format in the case where signal processing, such as error correction coding, data modulation, or spreading, is performed on information data and control data that includes interference canceller information, and then a pilot channel to be used for channel estimation and the like, a control channel including control data such as the interference canceller information, and a data channel including information data are time-multiplexed. FIG. 5 shows only an example, and a format in the case where those channels are frequency-multiplexed or code-multiplexed may be used.

The receiver 265 includes the A/D converter 206, the filter 207, the GI remover 208, the channel estimator 209, the weighting coefficient setter 210, the serial-to-parallel converter 211, the FFT unit 212, the channel compensator 213, the spreading code generator 215, the multipliers 216-1-1 to 216-m-1, the symbol multiplexers 217-1 to 217-m, a second deinterleaver 289, the parallel-to-serial converter 219, the demodulator 220, a first deinterleaver 288, and the error correction decoder 221. The A/D converter 206 converts an analog signal output from the radio frequency converter 202 into a digital signal. The filter 207 extracts a signal of a desired band from a signal output from the A/D converter 206. The GI remover 208 removes, from a signal output from the filter 207, a guard interval GI added by the base station 11 to prevent distortion caused by delayed waves.

The channel estimator 209 estimates a channel through which the received signal has been transmitted based on a control channel (reception information), a preamble, a pilot signal, and the like, which are included in the received signal. An estimation result includes a delay profile, delay spread characteristics, the maximum Doppler frequency, and the like, which are caused by multipath fading. The weighting coefficient setter 210 calculates a weighting coefficient for correcting channel distortion using, for example, MMSE (Minimum Mean Square Error) or MRC (Maximum Ratio Combing) based on signals output from the channel estimator 209.

The serial-to-parallel converter 211 performs serial-to-parallel conversion on a signal output from the GI remover 208. The FFT unit 212 performs Fourier transform to convert time domain signals output from the GI remover 208 into frequency signals. The channel compensator 213 multiplies signals output from the FFT unit 212 by a signal output from the weighting coefficient setter 210 to compensate channel distortion caused by, for example, fading. The code-channel signal processors 274-1 to 274-n perform signal processing on signals output from the channel compensator 213 for respective channel signals that are code-multiplexed to obtain information data. Each of the code-channel signal processors 274-1 to 274-n includes the spreading code generator 215, the multipliers 216-1-1 to 216-m-1, the symbol multiplexers 217-1 to 217-m, a second deinterleaver 289, the parallel-to-serial converter 219, the demodulator 220, a first deinterleaver 288, and the error correction decoder 221.

The spreading code generator 215 generates given inverse-spreading codes for the respective code-channel signal processors 274-1 to 274-m. The multipliers 216-1-1 to 216-m-1 multiply subcarrier signals by the spreading codes generated by the spreading code generator 215 to perform inverse spreading. Each of the symbol multiplexers 217-1 to 217-m multiplexes the given number of the inversely spread signal strings into one signal string. The second deinterleaver 289 deinterleaves the signals output from the symbol multiplexers 217-1 to 217-m using a reverse pattern of the interleave pattern used by the second interleaver 122 of the base station 11.

The parallel-to-serial converter 219 converts the parallel signal strings deinterleaved by the second deinterleaver 289 into a serial signal string. The demodulator 220 performs demodulation, such as QPSK or 16 QAM, on the signal output from the parallel-to-serial converter 219. The first deinterleaver 288 deinterleaves signals output from the demodulator 220 using a reverse pattern of the interleave pattern used by the first interleaver 119 of the base station 11. The error correction decoder 221 performs error correction decoding on the signal output from the deinterleaver 288 to obtain information data. The decoding performed by the error correction decoder 221 may be soft decision decoding or hard decision decoding.

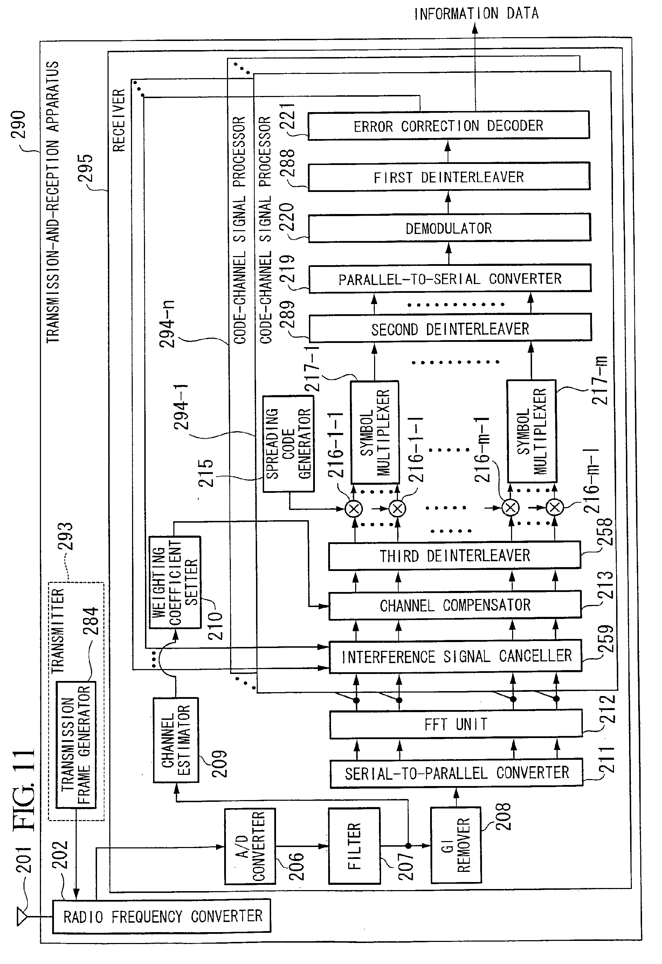

FIG. 11 is a schematic block diagram illustrating the configuration of a transmission-and-reception apparatus 290 included in the mobile station 5. The antenna 201 receives signals transmitted from the base station 11, or transmits signals generated by the transmission-and-reception apparatus 290. The radio frequency converter 202 performs frequency conversion of signals received from the base station 11 through the antenna 201 into baseband signals. Additionally, the radio frequency converter 202 converts signals generated by the transmission-and-reception apparatus 290 into transmittable frequency band signals. A transmitter 293 includes a transmission frame generator 284 and generates signals to be transmitted. These signals may be output based on a wireless communication system, such as an MC-CDM system, an OFDM system, a CDMA system, or a single-carrier modulation system, as long as a communication destination can restore transmitted data.

The transmission frame generator 284 generates data, such as information data, control data, category data, and the like, which are to be transmitted by the mobile station 5, performs signal processing, such as error correction coding, data modulation, and the like, and then arranges the processed data on a frame. FIG. 5 illustrates an example of data generated by the transmission frame generator 284. FIG. 5 shows a frame format in the case where signal processing, such as error correction coding, data modulation, or spreading, is performed on information data, control data, and category information, and then a pilot channel to be used for channel estimation and the like, a control channel including control data such as interference canceller information, and a data channel including information data are time-multiplexed. FIG. 5 shows only an example, and a format in the case where those channels are frequency-multiplexed or code-multiplexed may be used.

A receiver 295 obtains information data from the baseband signals output from the radio frequency converter 202. The receiver 295 includes the A/D converter 206, the filter 207, the GI remover 208, the channel estimator 209, the weighting coefficient setter 210, the serial-to-parallel converter 211, the FFT unit 212, and code-channel signal processors 294-1 to 294-n. The A/D converter 206 converts an analog signal output from the radio frequency converter 202 into a digital signal. The filter 207 extracts a signal of a desired band from a signal output from the A/D converter 206. The GI remover 208 removes, from a signal output from the filter 207, a guard interval GI added by the base station 11 to prevent distortion caused by delayed waves.

The channel estimator 209 estimates a channel through which the received signal has been transmitted based on a control channel, a preamble, a pilot signal, and the like, which are included in the received signal. An estimation result includes a delay profile, delay spread characteristics, the maximum Doppler frequency, and the like, which are caused by multipath fading. The weighting coefficient setter 210 calculates a weighting coefficient for correcting channel distortion using, for example, MMSE (Minimum Mean Square Error) or MRC (Maximum Ratio Combing) based on signals output from the channel estimator 209. The serial-to-parallel converter 211 performs serial-to-parallel conversion on a signal output from the GI remover 208. The FFT unit 212 performs Fourier transform to convert time domain signals output from the GI remover 208 into frequency signals.

The code-channel signal processors 294-1 to 294-n perform signal processing on signals output from the FFT unit 212 for respective channel signals that are code-multiplexed, and output information data. Each of the code-channel signal processors 294-1 to 294-n includes the interference signal canceller 259, the channel compensator 213, the third deinterleaver 258, the spreading code generator 215, the multipliers 216-1-1 to 216-m-1, the symbol multiplexers 217-1 to 217-m, the second deinterleaver 289, the parallel-to-serial converter 219, the demodulator 220, the first deinterleaver 288, and the error correction decoder 221.

The interference signal canceller 259 generates replicas of the non-desired signals causing multi-code interference MCI based on a soft decision result (or log likelihood) or a hard decision result which is input from the error correction decoder 221, and cancels the replicas of the non-desired signals from signals output from the FFT unit 212. The channel compensator 213 multiplies signals output from the interference signal canceller 259 by a signal output from the weighting coefficient setter 210 to compensate channel distortion caused by, for example, fading. The third deinterleaver 258 performs the inverse of the operation performed by the third interleaver 126 included in the base station 10. In other words, the third deinterleaver 258 performs deinterleaving by rearranging signals output from the channel compensator 213 using a reverse pattern of the interleave pattern used by the third interleaver 126.

The spreading code generator 215 generates given inverse-spreading codes for the respective code-channel signal processors 294-1 to 294-n. The multipliers 216-1-1 to 216-m-1 multiply subcarrier signals by the spreading codes generated by the spreading code generator to perform inverse spreading. Each of the symbol multiplexers 217-1 to 217-m multiplexes the given number of the inversely spread signal strings into one signal string. The second deinterleaver 289 performs the inverse of the operation performed by the second interleaver 122 included in the base station 11. In other words, the second deinterleaver 289 performs deinterleaving by rearranging signals output from the symbol multiplexers 217-1 to 217-m using a reverse pattern of the interleave pattern used by the second interleaver 122.

The parallel-to-serial converter 219 converts the parallel signal strings deinterleaved by the second deinterleaver 289 into a serial signal string. The demodulator 220 performs demodulation, such as QPSK or 16 QAM, on the signal output from the parallel-to-serial converter 219. The first deinterleaver 288 deinterleaves signals output from the demodulator 220 using a reverse pattern of the interleave pattern used by the first interleaver 119 of the base station 11. The error correction decoder 221 performs error correction decoding on the signal output from the first deinterleaver 288 to obtain information data. The decoding performed by the error correction decoder 221 may be soft decision decoding or hard decision decoding.

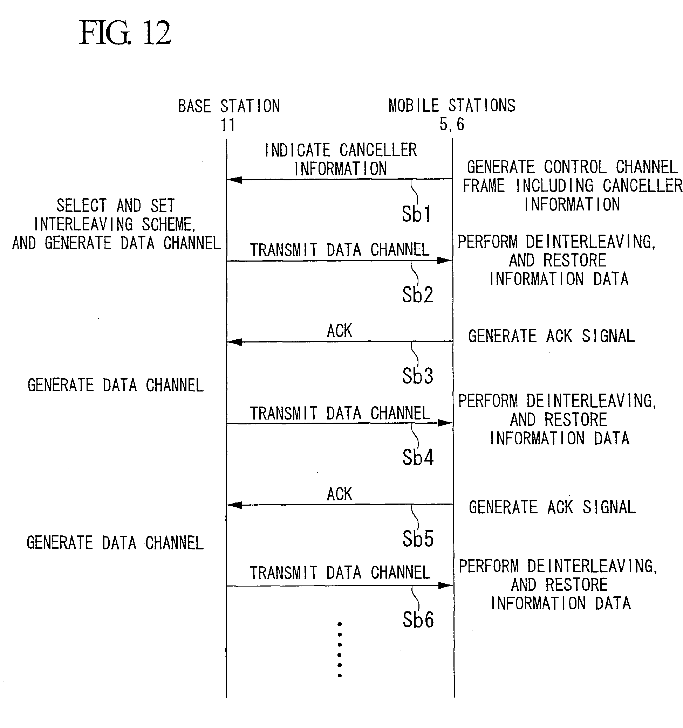

FIG. 12 is a sequence chart illustrating a flow of operations between the base station 11 and the mobile stations 5 and 6 according to the second embodiment. In the mobile stations 5 and 6, each of the transmission frame generators 264 and 284 generates a control channel frame including interference canceller information and transmits the control channel frame to the base station 11 so that the interference canceller information is indicated to the base station 11 (Sb1). Although the interference canceller information is indicated to the base station 11 by the control channel, a signal capable of indicating control information, such as a pilot channel or a preamble, may be used instead. The mobile station 5 shown in FIG. 8 indicates to the base station 11 that an interference canceller is included. The mobile station 6 shown in FIG. 8 indicates to the base station 11 that an interference canceller is not included.
In the base station 11, the reception signal restorer 135 obtains the interference canceller information included in the received control channel. Then, the interleave selector 138 selects an interleaving scheme corresponding to the presence or the absence of the interference canceller referring to the storage 139. Then, a data channel to be transmitted to the mobile station that has transmitted the interference canceller information is generated. Then, the generated data channel is transmitted to the mobile station (Sb2).

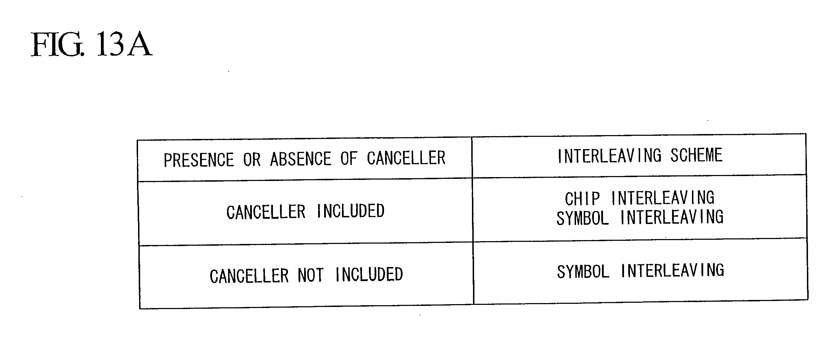

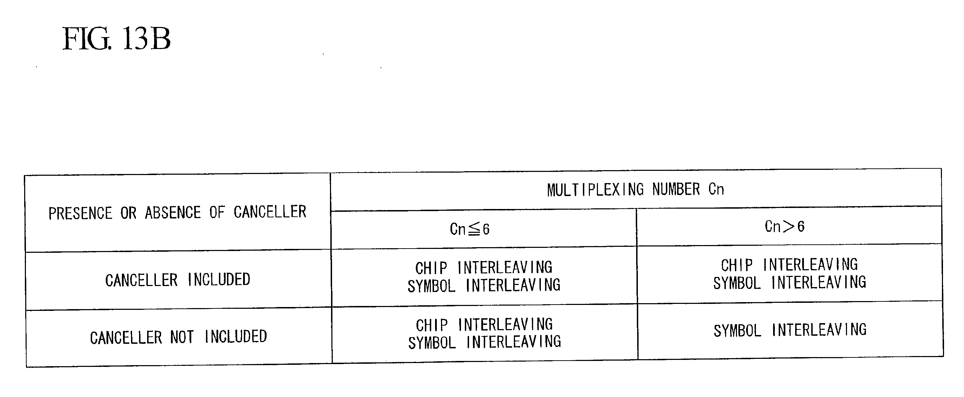

The storage 139 stores, for example, tables shown in FIGS. 13A and 13B. FIG. 13A illustrates an example of a table for selecting an interleaving scheme based on the presence or the absence of an interference canceller. Interleaving schemes are described correlated to the presence or the absence of an interference canceller. Specifically, chip (third) interleaving and symbol (second) interleaving are correlated to the presence of an interference canceller, and symbol (second) interleaving is correlated to the absence of interference canceller. FIG. 13B illustrates an example of a table for selecting an interleaving scheme based on the presence or the absence of an interference canceller, and the multiplexing number that is one of the transmission parameters. Interleaving schemes are described correlated to a combination of the presence or the absence of an interference canceller and whether the multiplexing number is 6 or more, or less than 6. Specifically, a combination of the absence of an interference canceller and the multiplexing number Cn that is 6 or more corresponds to symbol (second) interleaving, and the other combination corresponds to chip (third) interleaving and symbol (second) interleaving.

If the storage 139 stores the table shown in FIG. 13A, for example, a control channel including information indicating that an interference canceller is included is received, the interleave selector 138 selects chip interleaving and symbol interleaving as interleaving schemes. If the storage 139 stores the table shown in FIG. 13B, for example, a control channel including information indicating that an interference canceller is not included is received and the multiplexing number Cn=4, the interleave selector 138 selects chip interleaving and symbol interleaving as interleaving schemes. The interleave selector 138 instructs execution of interleaving based on the selected interleaving scheme. In other words, the interleave selector 138 instructs the third interleaver 126 to perform interleaving if chip interleaving is selected. Alternatively, the interleave selector 138 instructs the second interleaver 122 to perform interleaving if symbol interleaving is selected.

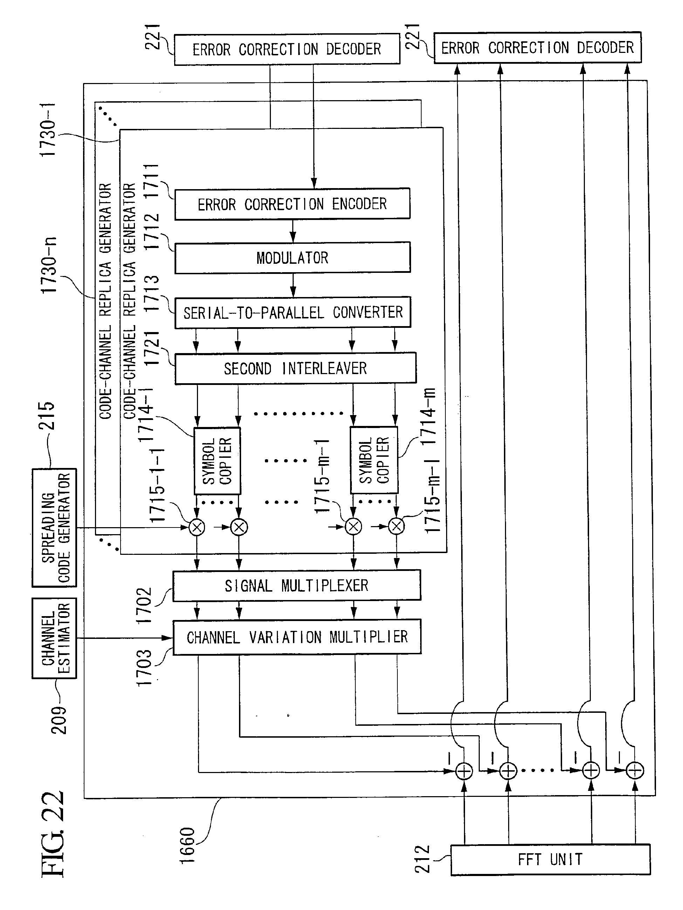

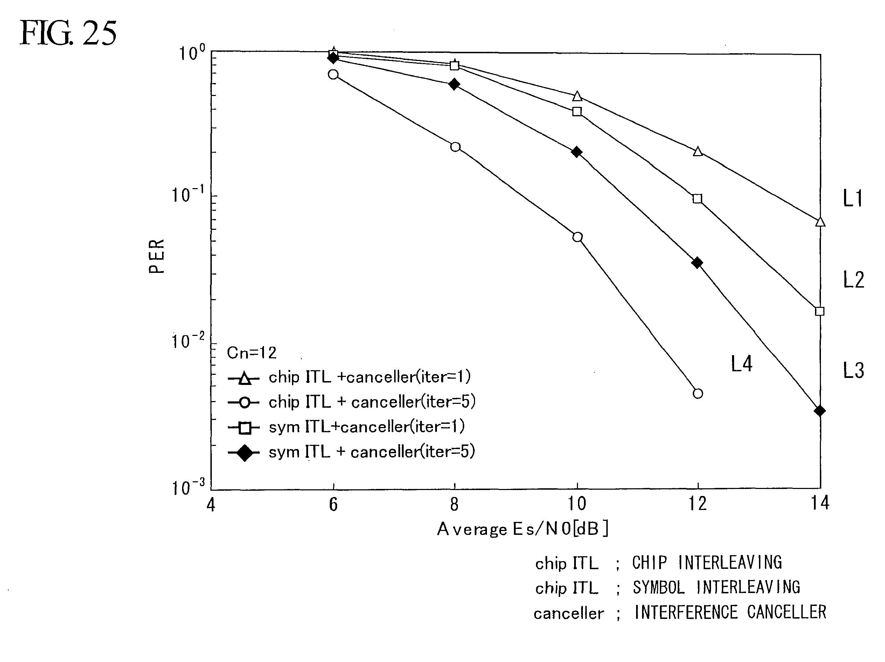

FIG. 25 illustrates a graph indicative of PER characteristics when an interleaving canceller is included or not included, and chip interleaving or symbol interleaving is used where the horizontal and vertical axes respectively represent reception power and PER (Packet Error Rate). The interference canceller shown in FIG. 22 is used. In FIG. 25, canceller (iter=1) indicates the absence of an interference canceller (corresponding to the presence of an interference canceller of the repetition number one). Canceller (iter=5) indicates the presence of an interference canceller of the repetition number five. When an interference canceller is not included, errors of information data can be reduced in the case (L2) of using symbol interleaving greater than in the case (L1) of using chip interleaving. When an interference canceller is included, on the other hand, errors of information data can be reduced in the case (L4) of using chip interleaving greater than in the case (L3) of using symbol interleaving. Thus, symbol interleaving is selected if an interference canceller is not included, and chip interleaving is selected if an interference canceller is included. Thereby, the reception performance of the mobile stations can maximally be enhanced.

The mobile station that is a transmission target receives the data channel, performs signal processing including deinterleaving based on the interleaving scheme used by the base station 11, and thereby restores information data. If more information data is required, the mobile station generates an ACK signal and transmits the generated ACK signal to the base station (Sb3). The ACK signal may or may not include interference canceller information. If the ACK signal is received from the mobile station, the base station 11 generates a data channel signal interleaved by an interleaving scheme the same as the previously used one, and transmits the generated data channel signal to the mobile station (Sb4). The same process from the sequence Sb2 repeats from the subsequent sequence Sb5 until necessary information data is transmitted.

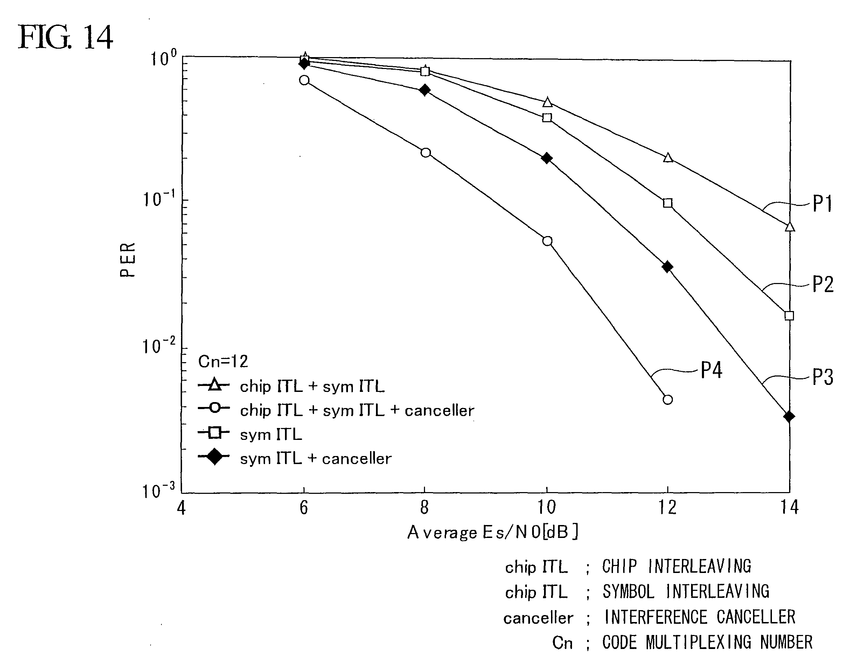

FIG. 14 illustrates a graph indicative of PER (Packet Error Rate) characteristics based on differences in interleaving schemes in the MC-CDM wireless communication system where the horizontal and vertical axes respectively represent reception power and PER. If an interference canceller is not included, the PER characteristics are worse in the case (P1) of chip interleaving than in the case (P2) of symbol interleaving. If an interference canceller is included, the PER characteristics are better in the case (P4) of chip interleaving than in the case (P3) of symbol interleaving. The reason is that multi-code interference (MCI) can be removed by an interference canceller and the frequency diversity effect can effectively be achieved by chip interleaving.

In other words, the mobile station device including no interference canceller as shown in FIG. 13A uses symbol interleaving in the system of the PER characteristics shown in FIG. 14. Even in the same communication circumstances, the mobile station device including an interference canceller uses chip interleaving, or chip and symbol interleaving. Thereby, excellent transmission efficiency can be achieved. As explained above, the mobile stations have different reception characteristics according to whether or not an interference canceller is included therein, and transmit data interleaved with an interleaving scheme suited to the reception characteristics of the mobile stations, enhancing reception performance thereof.

### [Third Embodiment]

A third embodiment is a modification of the second embodiment and explains a transmission and reception system in which an interleaving scheme is selected based on the interference canceller information and a transmission parameter, and the base station indicates a selection result to the mobile station. The case where the transmission parameter is the multiplexing number shown in FIG. 13B is explained.

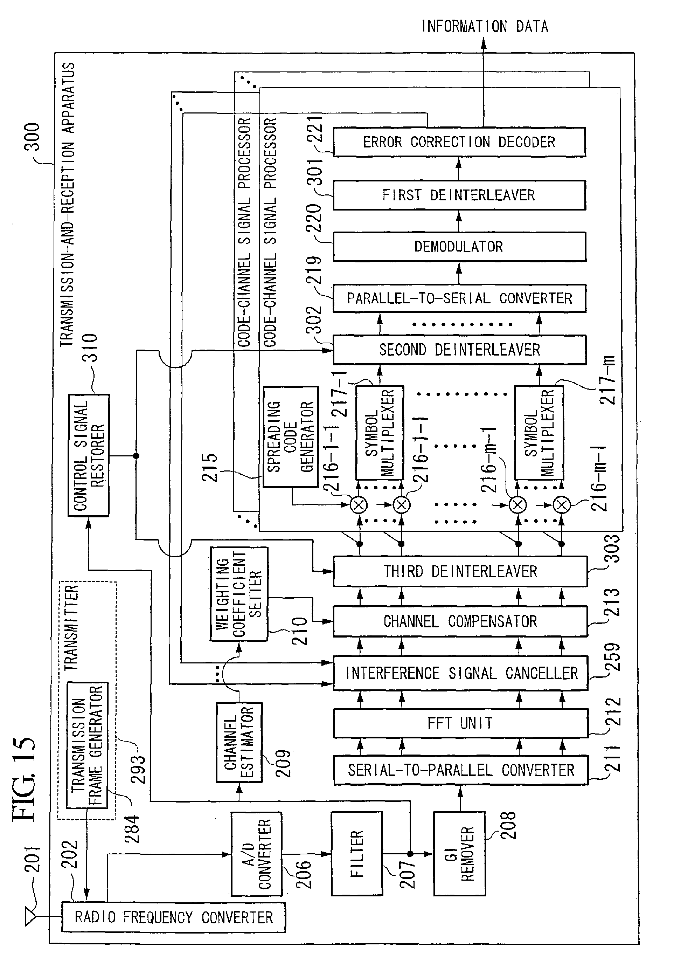

FIG. 15 is a schematic block diagram illustrating the configuration of a transmission-and-reception apparatus 300 included in a mobile station according to the third embodiment. Like reference numerals shown in FIG. 15 represent like units shown in FIG. 11, and explanations thereof are omitted. A control signal restorer 310 restores, from the signal received by the mobile station device from the base station 11, a control channel signal including information concerning an interleaving scheme determined based on the presence or the absence of an interference canceller and the multiplexing number, and thereby obtains an interleaving scheme applied to the data channel. When the interleaving scheme is obtained, the control signal restorer 310 instructs each deinterleaver to perform deinterleaving based on the obtained interleaving scheme.

If the interleaving scheme applied to the data channel output from the control signal restorer 310 is bit interleaving, a first deinterleaver 301 performs deinterleaving corresponding to the bit interleaving. If the interleaving scheme applied to the data channel output from the control signal restorer 310 is symbol interleaving, a second deinterleaver 302 performs deinterleaving corresponding to the symbol interleaving. If the interleaving scheme applied to the data channel output from the control signal restorer 310 is chip interleaving, the second deinterleaver 303 performs deinterleaving corresponding to the chip interleaving.

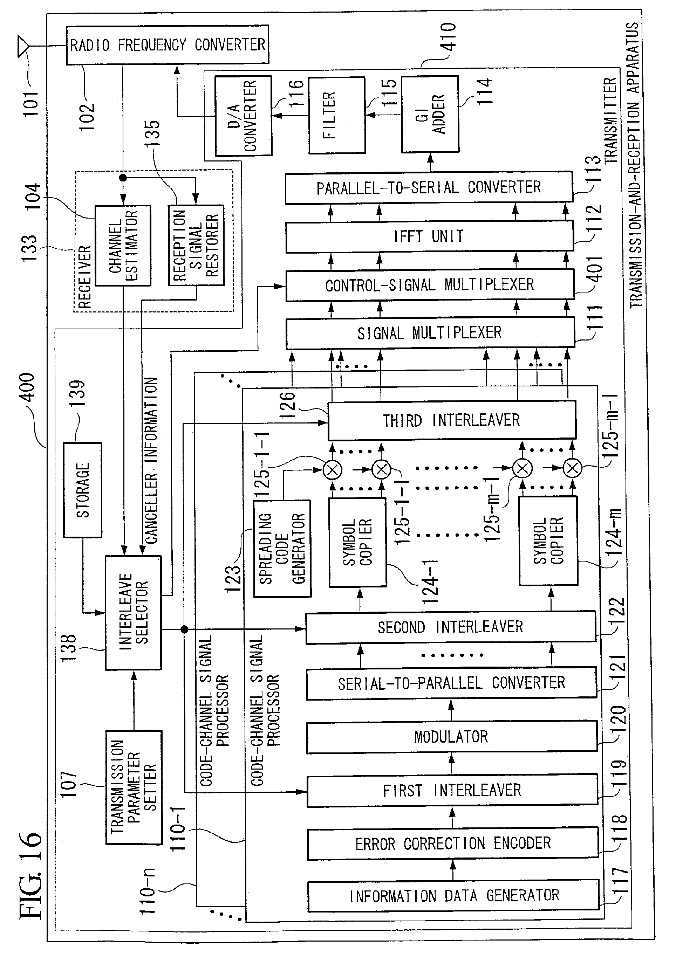

FIG. 16 is a schematic block diagram illustrating the configuration of a transmission-and-reception apparatus 400 included in the base station according to the third embodiment. Like reference numerals shown in FIG. 16 represent like units shown in FIG. 9, and explanations thereof are omitted. A transmitter 410 includes a control-signal multiplexer 401 in addition to the transmitter 136 shown in FIG. 9. The control-signal multiplexer 401 generates control information including information concerning the interleaving scheme selected by the interleave selector 13 8, generates a frame by multiplexing the control channel in which the control information is allocated and a data channel in which the data information received from the signal multiplexer 111 is allocated, and outputs the generated frame to the IFFT unit 112.

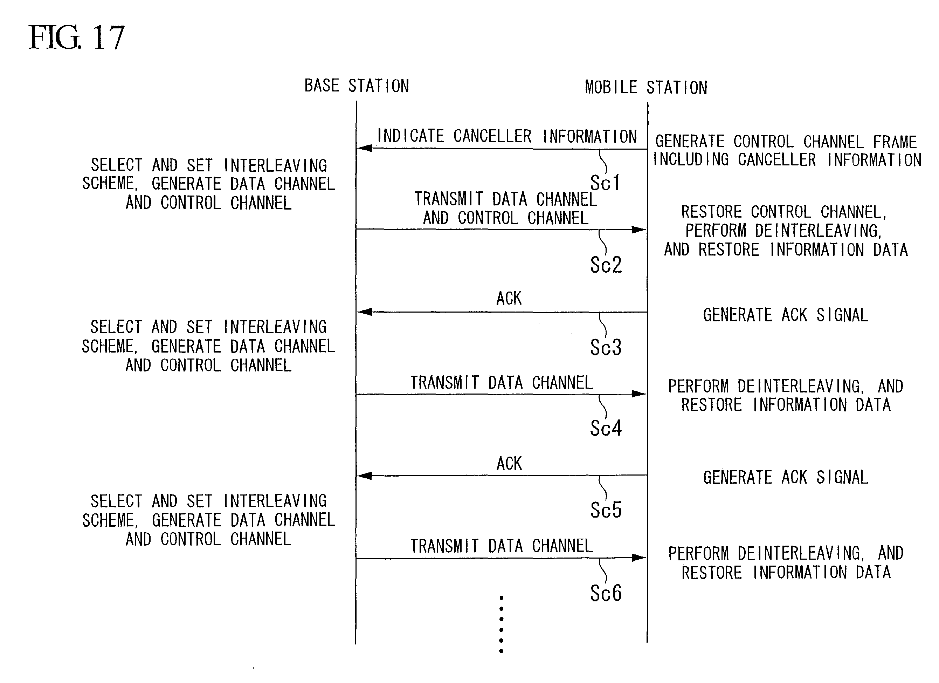

FIG. 17 is a sequence chart illustrating a flow of operations between the mobile station and the base station according to the third embodiment. In the mobile station, the transmission frame generator 284 generates a control channel frame including interference canceller information concerning the transmission-and-reception apparatus 300, and transmits the generated frame to the base station (Sc1). Since an interference canceller (interference signal canceller 259) is included, the interference canceller information indicates that an interference canceller is included. In the base station, the interleave selector 138 refers to the storage 139 and determines an interleaving scheme to be applied to a data channel based on the interference canceller information restored from the reception signal by the reception signal restorer 135 and the multiplexing number applied to the data channel. Then, the interleave selector 138 indicates the determined interleaving scheme to the first to third interleavers 119 to 126. Thereby, the transmitter 410 generates a data channel based on the determined interleaving scheme. Further, the control-signal multiplexer 401 receives the interleaving scheme determined by the interleave selector 138, and then generates control information including information concerning the interleaving scheme applied to the data channel based on the received interleaving scheme.

The base station transmits the generated data channel and the control channel including the control information to the mobile station (Sc2). The mobile station receives the data channel and the control channel from the base station. Then, the control signal restorer 310 restores the control channel to obtain the interleaving scheme applied to the data channel. The control signal restorer 310 instructs the first to third deinterleavers 301 to 303 to perform deinterleaving corresponding to the interleaving scheme information. Then, the mobile station performs signal processing, such as deinterleaving based on the interleaving scheme information, inverse spreading, demodulation, and decoding, on the data channel to restore information data. If more information data is required, the mobile station generates an ACK signal and transmits the generated ACK signal to the base station (Sc3). The ACK signal may or may not include interference canceller information. If the ACK signal is received from the mobile station, the base station determines an interleaving scheme based on the interference canceller information and the multiplexing number of data symbols, and generates data channel signals interleaved based on the determined interleaving scheme. Further, the base station generates control channel information including information concerning the interleaving scheme applied to the data channel. Then, the base station transmits the generated data channel and the control channel to the mobile station (Sc4).

The mobile station receives the data channel and the control channel from the base station. Then, the control signal restorer 310 restores the control channel to obtain the information concerning the interleaving scheme applied to the data channel. Then, the mobile station performs signal processing, such as deinterleaving based on the interleaving scheme information, inverse spreading, demodulation, and decoding, on the data channel to restore information data. Then, the sequence from the Sc3 repeats from the subsequent sequence Sc5 until necessary information data is transmitted.

As explained above, an interleaving scheme is determined based on interference canceller information and a transmission parameter. Thereby, an optimal interleaving scheme can be selected in consideration of circumstance information and the reception characteristics of mobile stations, achieving the maximum reception characteristics of mobile stations.

### [Fourth Embodiment]

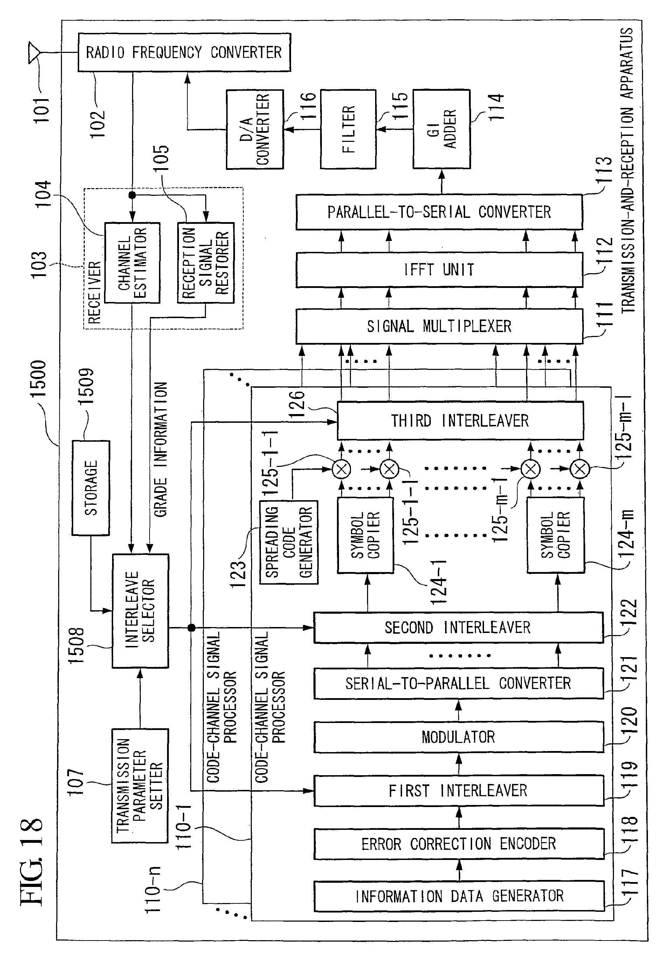

Hereinafter, a fourth embodiment explains the case where an interleaving scheme is selected based on the grade of an interference canceller included in a receiver of a transmission-and-reception apparatus included in a mobile station in an MC-CDM wireless communication system. FIG. 18 is a schematic block diagram illustrating the configuration of a transmission-and-reception apparatus 1500 included in a base station according to the fourth embodiment. Like reference numerals shown in FIG. 18 represent like units shown in FIG. 2, and explanations thereof are omitted.

An interleave selector 1508 refers to a storage 1509 to obtain an interleaving scheme corresponding to grade information concerning an interference canceller that is output from the reception signal restorer 105, and then selects the obtained interleaving scheme as one to be applied to a transmission signal. The interleave selector 1508 may select an interleaving scheme to be applied based on at least one of the grade information concerning an interference canceller, a channel estimation value estimated by the channel estimator 104, and a transmission signal parameter. The storage 1509 stores interleaving-scheme information corresponding to at least one of the grade information concerning an interference canceller, a combination of the grade information concerning an interference canceller and a channel estimation value estimated by the channel estimator 104, and a combination of the grade information concerning an interference canceller and a transmission signal parameter. The grade information is one of the category information, but different from the aforementioned one.

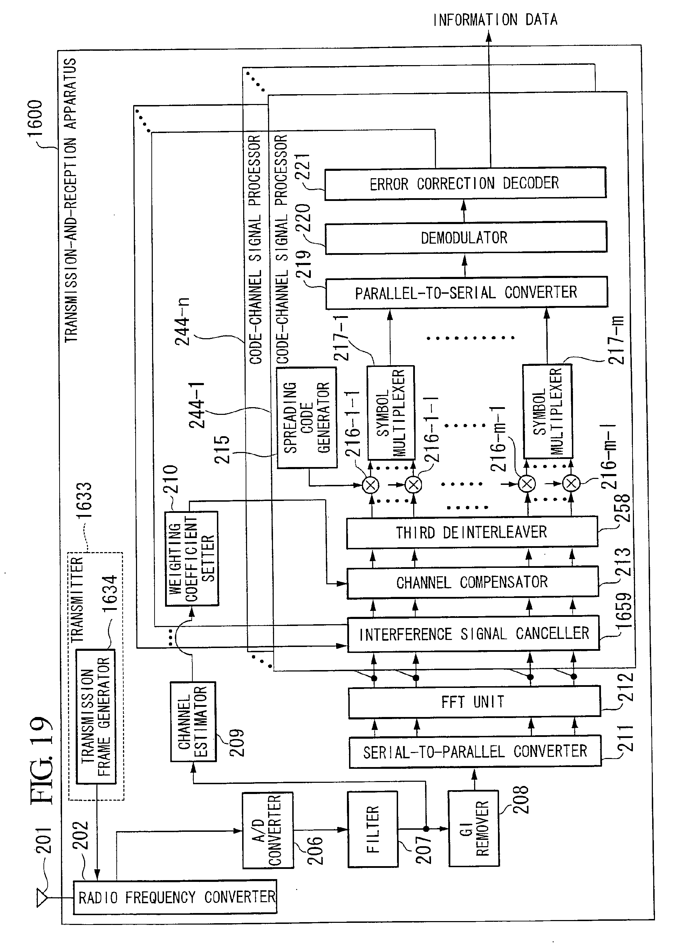

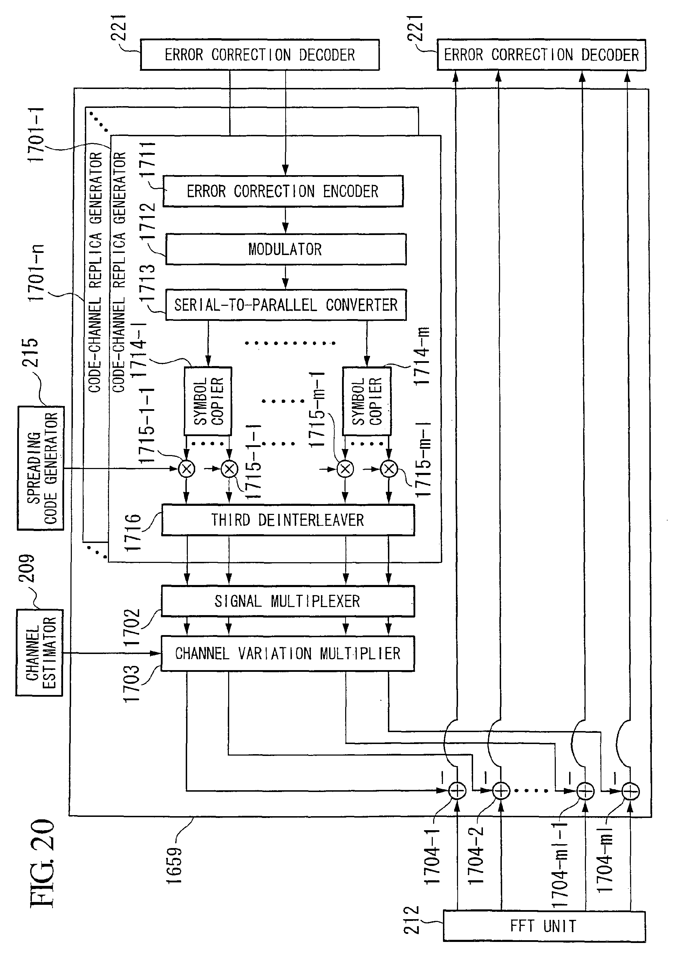

FIG. 19 is a schematic block diagram illustrating the configuration of a transmission-and-reception apparatus 1600 included in a mobile station that selects chip interleaving (third interleaver 126). Like reference numerals shown in FIG. 19 represent like units shown in FIG. 4, and explanations thereof are omitted. A transmission frame generator 1634 generates data including information data to be transmitted by the mobile station and control information including grade information concerning an interference canceller. Then, the transmission frame generator 1634 performs signal processing that is any of error correction coding, data modulation, and spreading on the generated data, and arranges the processed data in a frame. Similar to the interference signal canceller 259, an interference signal canceller 1659 generates replicas of undesired signals causing multi-code interference MCI based on a soft decision result (or log likelihood ratio) or a hard decision result that is input from the error correction decoder 221, and cancels the replicas of the undesired signals from signals output from the FFT unit 212. The interference signal canceller 1659 is explained in detail with reference to FIG. 20.

FIG. 20 is a schematic block diagram illustrating the inner configuration of the interference signal canceller 1659. The interference signal canceller 1659 receives signals output from the error correction decoding 221 and includes code-channel replica generators 1701-1 to 1701-n that respectively generate signals (replicas) of respective code channels considered to be generated by the base station. The details of the code-channel replica generators 1701-1 to 1701-n will be explained later. The signal multiplexer 1702 multiplexes signals belonging to code channels other than the desired channel from among the signals output from the code-channel replica generators 1701-1 to 1701-n. A channel variation multiplier 1703 multiplies the outputs from the signal multiplexer 1702 by the channel estimation value estimated by the channel estimator 209. Subtractors 1704-1 to 1704-ml subtract the outputs of the channel variation multiplier 1703 from the outputs of the FFT unit 212, and output a subtraction result to the channel compensator 213.

Each of the code-channel replica generators 1701-1 to 1701-n includes an error correction encoder 1711, a modulator 1712, a serial-to-parallel converter 1713, symbol copiers 1714-1 to 1714-m, multipliers 1715-1-1 to 1715-m-1, and a third interleaver 1716. The error correction encoder 1711 performs error correction coding on a signal output from the error correction decoder 221. This error correction coding is the same as the error correction coding performed on the reception signals. The modulator 1712 performs data modulation, such as QPSK or 16 QAM, on a signal output from the error correction coding 1711. This data modulation is the same as the data modulation performed on the reception signals. The serial-to-parallel converter 1713 converts a serial signal string output from the modulator 1712 into parallel signal strings. The symbol copiers 1714-1 to 1714-m copy the signals output from the serial-to-parallel converter 1713 according to the length or cycle of a spreading code string generated by the spreading code generator 215. The multipliers 1715-1-1 to 1715-m-1 multiply outputs of the symbol copiers 1714-1 to 1714-m by the spreading codes output from the spreading code generator 215 to perform code spreading. The third interleaver 1716 performs chip interleaving on the spread signals output from the multipliers 1715-1-1 to 1715-m-1.

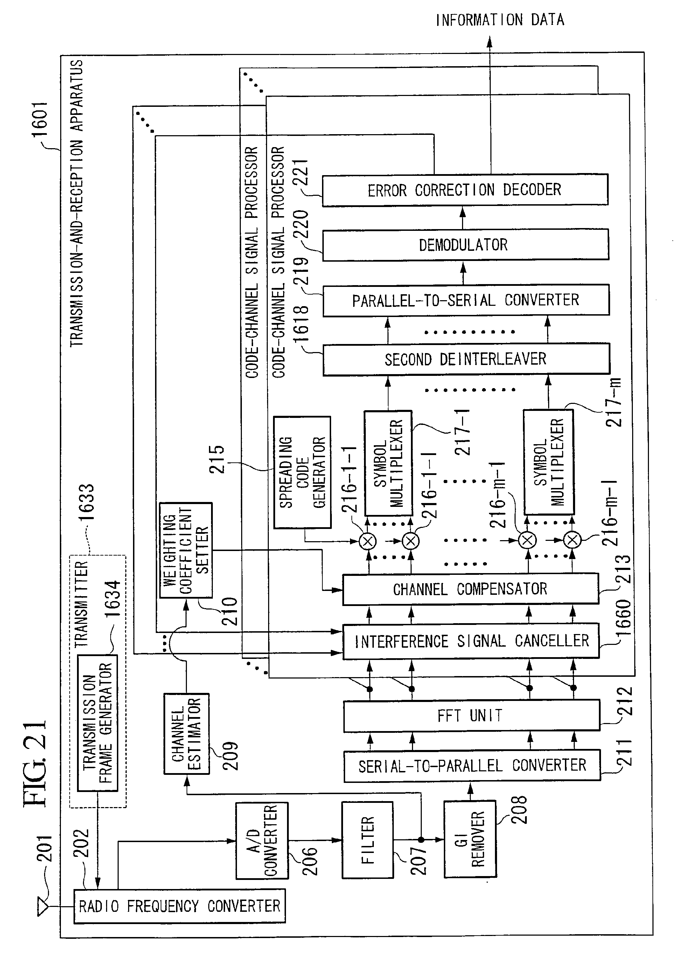

FIG. 21 is a schematic block diagram illustrating the configuration of a transmission-and-reception apparatus 1601 included in a mobile station that selects symbol interleaving (second interleaver 122). Like reference numerals shown in FIG. 21 represent like units shown in FIG. 19, and explanations thereof are omitted.
A second deinterleaver 1618 deinterleaves the signals output from the symbol multiplexers 217-1 to 217-m using an inverse pattern of the pattern used for the symbol interleaving performed by the second interleaver 122. Similar to the interference signal cancellers 259 and 1659, an interference signal canceller 1660 generates replicas of undesired signals causing multi-code interference MCI based on a soft decision result (or log likelihood ratio) or a hard decision result that is input from the error correction decoder 221, and cancels the replicas of the undesired signals from signals output from the FFT unit 212. The interference signal canceller 1660 is explained in detail with reference to FIG. 22.

FIG. 22 is a schematic block diagram illustrating the inner configuration of the interference signal canceller 1660. Like reference numerals shown in FIG. 22 represent like units shown in FIG. 20, and explanations thereof are omitted. The interference signal canceller 1660 includes a second interleaver 1721 that performs symbol interleaving on the signals output from the serial-to-parallel converter 1713.

In the interference signal canceller 1659 shown in FIG. 20, replicas of undesired channel signals causing multi-code interference are generated by the code-channel replica generators 1701-1 to 1701-n, the signal multiplexer 1712, and the channel variation multipliers 1703, and then the replicas of the undesired channel signals are removed from the signals output from the FFT unit 212, thereby reducing multi-code interference elements from the reception signals. The signals output from the subtractors 1704-1 to 1704-ml with the multi-code interference elements being reduced are subjected to deinterleaving, inverse spreading, demodulation, and error correction decoding which are performed by the code-channel signal processors 244-1 to 244-n to obtain information data. The obtained information data is data restored from the signals with the multi-code interference reduced, and therefore includes lesser errors. Further, the data including lesser errors is used for the interference signal canceller 1659 to generate replicas of undesired signals again. Thereby, precise replicas can be generated. By repeating generation and subtraction of replicas of undesired signals, precision of replicas can be enhanced, and information data including lesser errors can be obtained.

As the repetition number increases, processing delay of the mobile stations increases. Therefore, the repetition number has to be changed based on the type of data or QoS used by the mobile stations in some cases. In data communication, for example, processing delay may be large, but data loss is preferably and illimitably zero. Therefore, the repetition number can be increased. In audio communication, on the other hand, data loss has not to be zero, but large processing delay is not allowed. Therefore, the repetition number is decreased. The mobile stations of different repetition numbers are present according to requirement conditions of data.

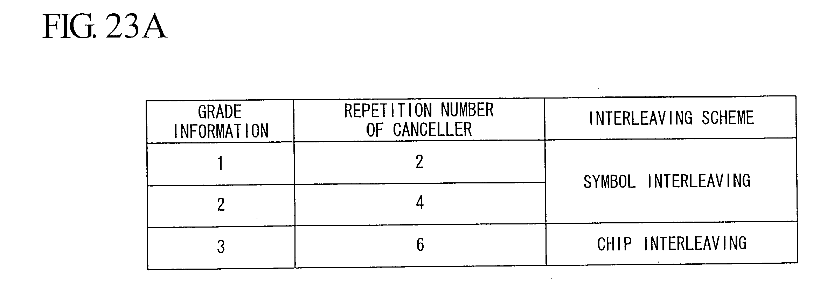

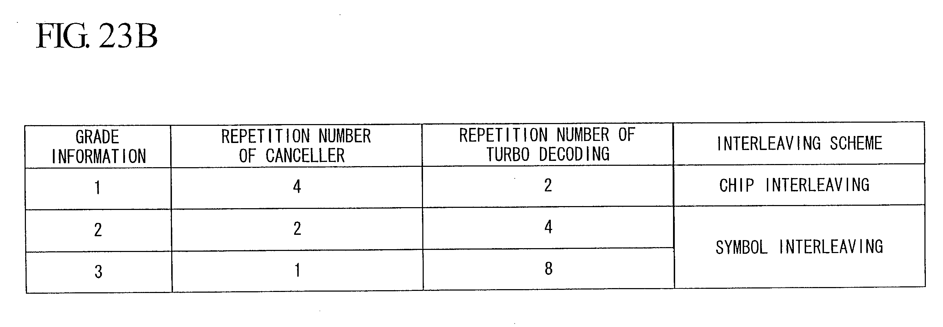

FIGS. 23A and 23B illustrate interleave selection tables stored in the storage 1509 of the base station. The interleave selection table shown in FIG. 23A is graded by the repetition number of an interference canceller (when the repetition number of an interference canceller is "2", "4", or "6", corresponding grade information is respectively "1 ", "2", or "3 "). Additionally, the interleave selection table stores interleaving schemes corresponding to the grade information (if the grade information is "1" or "2", the interleaving scheme is "symbol interleaving", and if the grade information is "3", the interleaving scheme is "chip interleaving"). In FIG. 23A, a mobile station that indicates the grade information "1" or "2" includes the transmission-and-reception apparatus 1601 shown in FIG. 21. A mobile station that indicates the grade information "3" includes the transmission-and-reception apparatus 1600 shown in FIG. 19.

The interleave selection table shown in FIG. 23B is graded by the repetition numbers of an interference canceller and turbo decoding (when the combination of the repetition numbers of an interference canceller and turbo decoding is "4, 2", "2, 4", or "1, 8", corresponding grade information is respectively " 1 ", "2", or "3"). Additionally, the interleave selection table stores interleaving schemes corresponding to the grade information (if the grade information is "1 ", the interleaving scheme is "chip interleaving", and if the grade information is "2" or "3", the interleaving scheme is "symbol interleaving"). In FIG. 23B, a mobile station that indicates the grade information "1" includes the transmission-and-reception apparatus 1600 shown in FIG. 19. A mobile station that indicates the grade information "2" or "3" includes the transmission-and-reception apparatus 1601 shown in FIG. 21. Although the tables shown in FIGS. 23A and 23B are graded by the repetition numbers of an interference canceller and turbo decoding, the tables may be graded by an indicator including a transmission parameter.

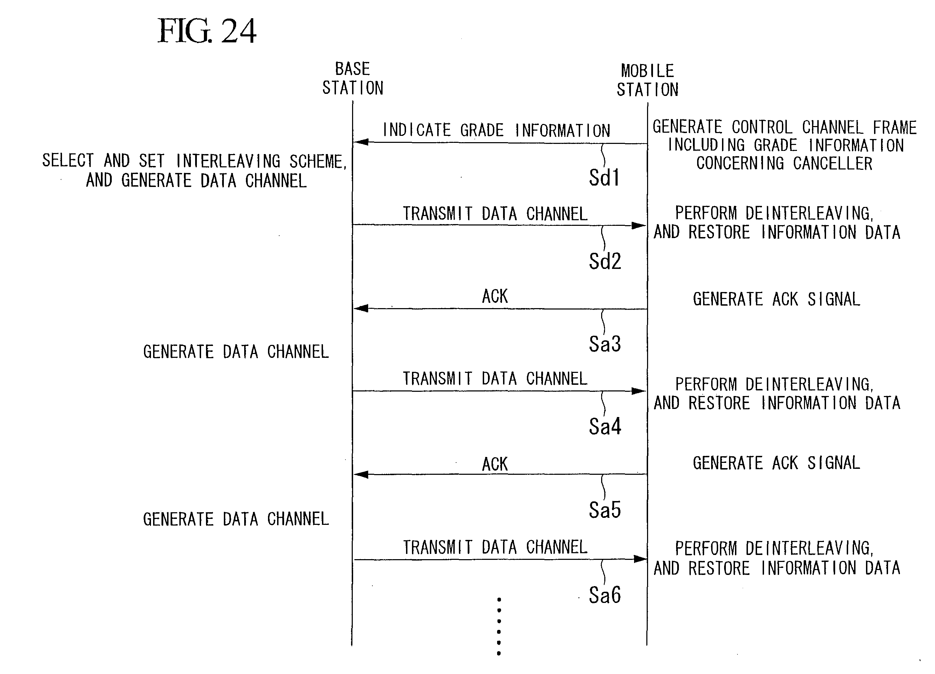

FIG. 24 is a sequence chart illustrating a flow of operations between the base station and the mobile station according to the fourth embodiment. The mobile station generates a control channel frame including grade information concerning an interference canceller, and indicates the generated frame to the base station (Sd1). Although the grade information concerning the interference canceller is indicated by the control channel, a signal capable of indicating control information, such as a pilot channel or a preamble, may be used. The base station selects an interleaving scheme based on the grade information concerning the interference canceller included in the received control channel. Then, the base station performs interleaving based on the selected interleaving scheme. Then, the base station generates a data channel and transmits the generated data channel to the mobile station (Sd2).
Then, operations similar to the sequence Sa3 to Sa6 shown in FIG. 6 continue. Although grade information based on the repetition number of an interference canceller is indicated in the case of FIG. 24, the repetition number may directly be indicated.

FIG. 25 illustrates a graph indicative of PER characteristics when chip interleaving or symbol interleaving is used when the repetition number (iter) of the interference canceller is one or five where the horizontal and vertical axes respectively represent reception power and PER (Packet Error Rate). When the repetition number of the interference signal canceller is one, errors of information data can be reduced in the case (L2) of using symbol interleaving greater than in the case (L1) of using chip interleaving. When the repetition number of the interference signal canceller is five, on the other hand, errors of information data can be reduced in the case (L4) of using chip interleaving greater than in the case (L3) of using symbol interleaving.
As a result, symbol interleaving is selected if the repetition number of the interference signal canceller is one, and chip interleaving is selected if the repetition number of the interference signal canceller is five. Thereby, the reception performance of the mobile stations can maximally be enhanced.

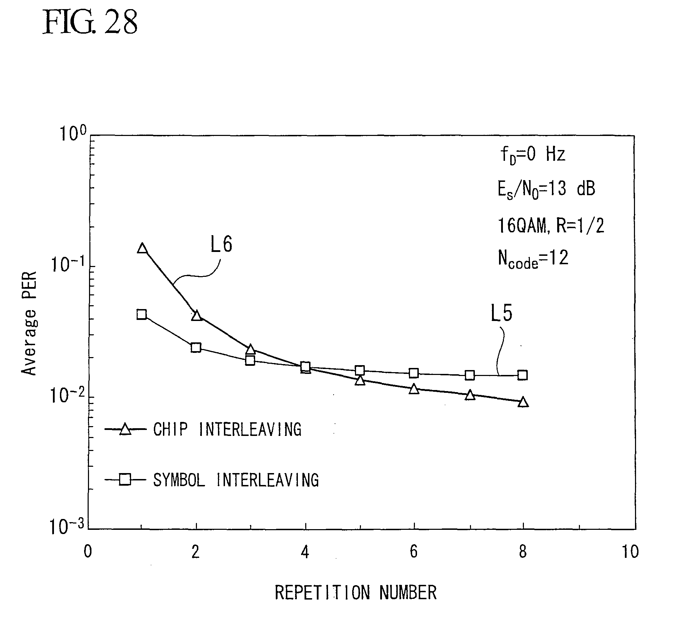

FIG. 28 illustrates a graph indicative of PER characteristics with respect to the repetition number of the interference signal canceller when chip interleaving or symbol interleaving is used where the horizontal and vertical axes respectively represent reception power and PER (Packet Error Rate). The interference canceller has the configuration shown in FIG. 22. In the section where the repetition number is one to four, errors of information data can be reduced greater in the case (L5) of using symbol interleaving. In the section where the repetition number is four to eight, errors of information data can be reduced greater in the case (L6) of using chip interleaving. The reason is that multi-code interference can more precisely be cancelled as the repetition number is larger. As a result of FIG. 28, the reception performance of the mobile stations can maximally be enhanced by the use of the table shown in FIG. 23A. When the repetition number is four in FIG. 28, the PER of the chip interleaving is substantially the same as that of the symbol interleaving. Therefore, symbol interleaving is selected in FIG. 23A. Since the range of rearrangement is small in the case of symbol interleaving than in the case of chip interleaving (the size of interleaving can be reduced), a reduction in a calculation amount can be achieved.

Although selection of an interleaving scheme based on the repetition number of an interference canceller has been explained, an interleaving scheme can be selected based on the repetition number of turbo decoding. Alternatively, an interleaving scheme can be selected based on the repetition number when a turbo equalizer that repeatedly performs decoding between an interference signal canceller and a turbo decoder is used.

### [Fifth Embodiment]

Hereinafter, a fifth embodiment explains, as a modification of the fourth embodiment, the case where grade information of an interference canceller is based on the type of the interference canceller. A PIC (Parallel Interference Canceller) and an SIC (Successive Interference Canceller) are known as interference cancellers. The PIC can precisely cancel interference elements by repeating processing, but errors included in the result of the first decoding affect the second and subsequent decoding. Thereby, the characteristics are not improved so much as the case of the SIC. Further, the PIC can parallelly perform signal processing for each code channel, and therefore processing delay does not depend on the code multiplexing number. If the code multiplexing number is large, the processing delay becomes smaller than that in the case of the SIC. The SIC sequentially performs decoding and interference cancelling for each code channel upon repetition of processing, and therefore lesser errors affect the subsequent processing. Thereby, the SIC can cancel interference elements more precisely than the PIC. Further, the SIC sequentially performs decoding and interference cancelling for each code channel, and therefore processing delay depends on the code multiplexing number. If the code multiplexing number is large, processing delay is larger than that in the case of the PIC.

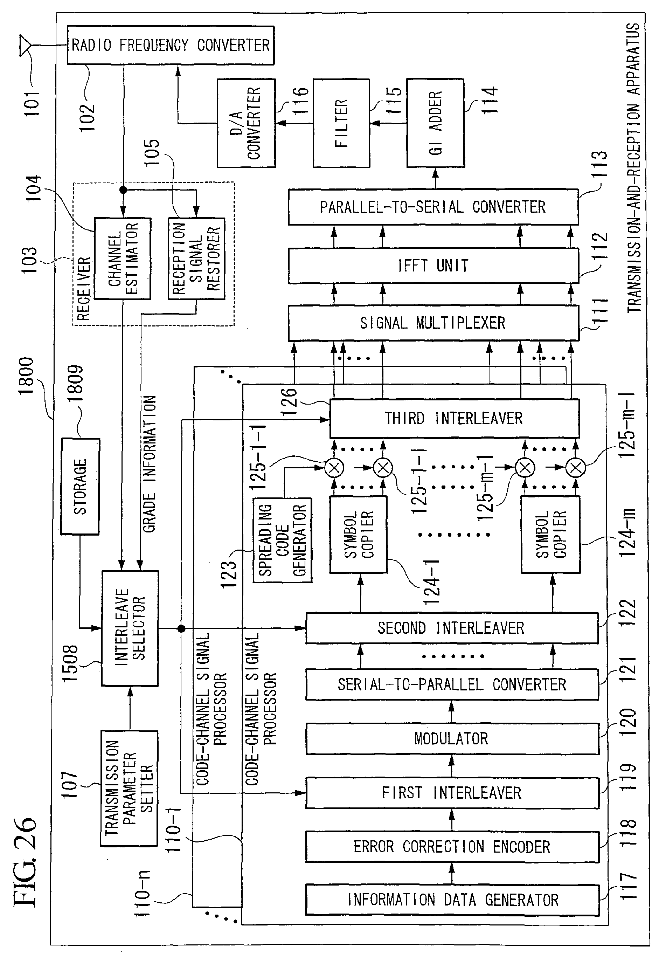

FIG. 26 is a schematic block diagram illustrating the configuration of a transmission-and-reception apparatus 1800 included in a base station according to the fifth embodiment. Like reference numerals shown in FIG. 26 represent like elements shown in FIG. 18, and explanations thereof are omitted. The transmission-and-reception apparatus 1800 includes a storage 1809 that stores assignment information concerning interleaving schemes corresponding to grade information based on the type of an interference canceller, a combination of the grade information and a channel estimation value estimated by the channel estimator 104, or a combination of the grade information and a transmission parameter.

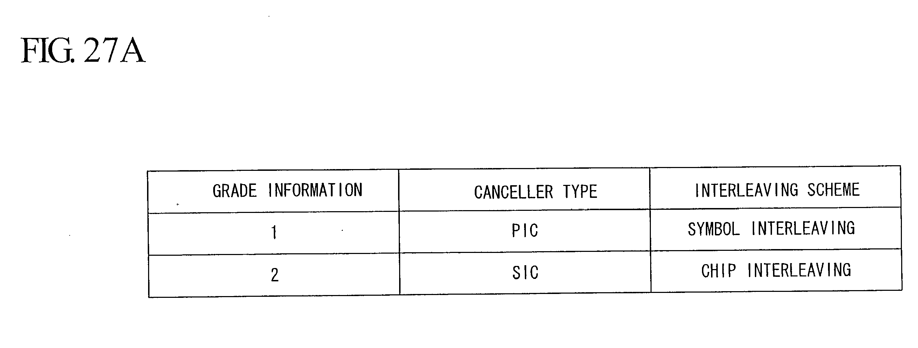

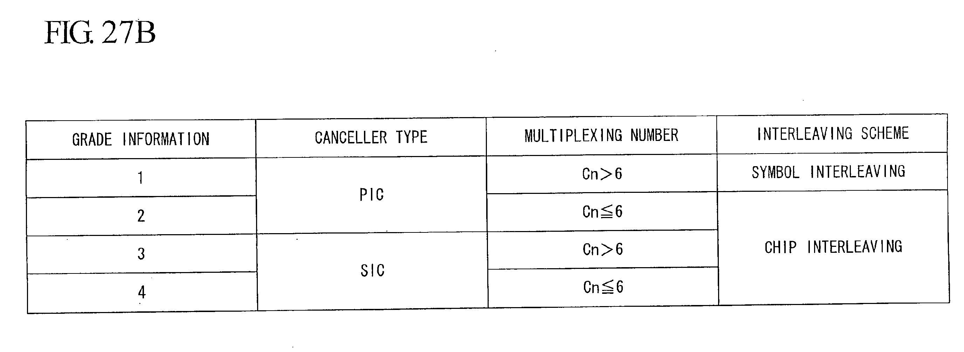

FIGS. 27A and 27B illustrate examples of tables for selecting an interleaving scheme which are stored in the storage 1809. FIG. 27A illustrates an example of a table for selecting an interleaving scheme when the grade of an interference canceller is determined based on the type of the interference canceller. The grade information "1" corresponds to the interference canceller type of "PIC" and the interleaving scheme of "symbol interleaving". The grade information "2" corresponds to the interference canceller type of "SIC" and the interleaving scheme of "chip interleaving". As shown in FIG. 27A, a mobile station including the SIC having high multi-code-interference cancelling capacity performs chip interleaving. Thereby, the frequency diversity effect can efficiently be achieved, and the reception characteristics of the mobile station can maximally be enhanced.

FIG. 27B illustrates an example of a table for selecting an interleaving scheme when the grade of an interference canceller is determined based on the type of the interference canceller and the multiplexing number. The grade information "1" corresponds to the interference canceller type of "PIC", the multiplexing number of "Cn>6", and the interleaving scheme of "symbol interleaving". The grade information "2" corresponds to the interference canceller type of "PIC", the multiplexing number of "Cn≤6", and the interleaving scheme of "chip interleaving". The grade information "3" corresponds to the interference canceller type of "SIC", the multiplexing number of "Cn>6", and the interleaving scheme of "chip interleaving". The grade information "4" corresponds to the interference canceller type of "SIC", the multiplexing number of "Cn≤6", and the interleaving scheme of "chip interleaving". Cn is the multiplexing number. As shown in FIG. 27B, the mobile station selects an interleaving scheme in consideration of interference elements that vary depending on the interference cancelling capacity of PIC or SIC and the multiplexing number. Thereby, the frequency diversity effect can efficiently be achieved, and the reception characteristics of the mobile station can maximally be achieved.

Although an interleaving scheme is selected based on the interference cancelling capacity of PIC and SIC, the configuration is applicable to the case where a waveform shaping technology, such as the PIC, the SIC, or a turbo equalizer, is used. Operations between the base station and the mobile station are similar to those shown in FIG. 24. An interference cancelling scheme may directly be indicated instead of the grade information concerning an interference canceller. As explained above, an interleaving scheme is selected based on the grade of an interference canceller based on an interference cancelling capacity thereof, and thereby the reception characteristics of the mobile station can maximally be achieved.

Similar to the third embodiment, the interleaving scheme selected by the base station may be indicated to the mobile station so that the mobile station performs deinterleaving based on the indicated interleaving scheme in the fourth and fifth embodiments.

The channel estimator 104, the reception signal restorers 105 and 135, the transmission parameter setter 107, the interleave selectors 108, 138, and 1508, the storages 109, 139, 1509, and 1809, the code-channel signal processors 110-1 to 110-n, the signal multiplexer 111, the IFFT unit 112, the parallel-to-serial converter 113, the GI adder 114, the filter 115, the transmission frame generators 204, 234, 264, 294, and 1634, the filter 207, the GI remover 208, the channel estimator 209, the weighting coefficient setter 210, the serial-to-parallel converter 211, the FFT unit 212, the channel compensator 213, the code-channel signal processors 214-1 to 214-n, 244-1 to 244-n, 274-1 to 274-n, and 294-1 to 294-n, the first deinterleavers 288 and 301, the second deinterleavers 289 and 302, the third deinterleavers 258 and 303, the interference signal cancellers 259, 1659, and 1660, the control signal restorer 310, the control-signal multiplexer 401, which are explained in the first to fifth embodiments, may be implemented by hardware. Additionally, each of those units may include memory and a CPU (Central Processing Unit), and a function of each unit may be implemented by a program for implementing the function being loaded onto the memory and executed.

Although the embodiments of the present invention have been explained in detail with reference to the accompanying drawings, the specific configuration is not limited thereto, and various modifications can be made without departing from the scope of the present invention.

### INDUSTRIAL APPLICABILITY

The present invention is preferably used for, but not limited to, a transmission-and-reception apparatus that code-multiplexes signals and transmits the code-multiplexed signals, such as a cellular phone and a base station thereof, and a transmission-and-reception apparatus that receives the code-multiplexed signals.

## Claims

1. A transmission-and-reception apparatus, comprising:
a receiver that receives category information concerning a function of another transmission-and-reception apparatus as a target apparatus;
a selector that selects an interleaving scheme based on the category information; and
an interleaver that interleaves signals to be transmitted to the other transmission-and-reception apparatus based on the interleaving scheme.

2. The transmission-and-reception apparatus according to claim 1, further comprising a control-signal multiplexer that generates a control signal including information indicative of the interleaving scheme, and multiplexes the signals interleaved and the control signal.

3. The transmission-and-reception apparatus according to claim 1 or 2, further comprising a code multiplexer that multiplies a plurality of code channel signals respectively by unique spreading codes, and multiplexes the code channel signals to generate the signals to be transmitted.

4. A transmission-and-reception apparatus, comprising:
a transmitter that transmits category information concerning a function of the transmission-and-reception apparatus as a target apparatus; and
a deinterleaver that deinterleaves reception signals based on an interleaving scheme corresponding to the category information.

5. A transmission-and-reception apparatus, comprising:
a transmitter that transmits category information concerning a function of the transmission-and-reception apparatus as a target apparatus;
a control-signal demodulator that demodulates a control signal received and extracts information indicative of an interleaving scheme; and
a deinterleaver that deinterleaves reception signals based on the interleaving scheme.

6. The transmission-and-reception apparatus according to claim 4 or 5, further comprising a code demultiplexer that multiplies the reception signals deinterleaved by spreading codes to extract code channel signals corresponding to the spreading codes.

7. The transmission-and-reception apparatus according to any one of claims 1, 4 and 5, wherein the category information comprises information indicating whether or not an interference canceller that cancels interference signals from signals received from the target apparatus is included.

8. The transmission-and-reception apparatus according to claim 7, wherein the category information comprises grade information indicative of capacity of the interference canceller.

9. The transmission-and-reception apparatus according to claim 8, wherein the grade information is based on the repetition number of processing performed by the interference canceller.

10. The transmission-and-reception apparatus according to claim 8, wherein the grade information is based on an interleaving scheme used by the interference canceller.

11. The transmission-and-reception apparatus according to any one of claims 1, 4 and 5, wherein the category information comprises information based on a frequency bandwidth used by the target apparatus.

12. The transmission-and-reception apparatus according to any one of claims 1, 4 and 5, wherein the category information comprises information based on a modulation level for transmission performed by the target apparatus.

13. The transmission-and-reception apparatus according to any one of claims 1, 4 and 5, wherein the category information comprises information based on a code multiplexing number used by the target apparatus.

14. The transmission-and-reception apparatus according to any one of claims 1, 4 and 5, wherein the category information comprises information based on a repetition number of error correction decoding performed by the target apparatus.

15. A transmission-and-reception system including a first transmission-and-reception apparatus and a second transmission-and-reception apparatus that transmits interleaved signals to the first transmission-and-reception apparatus,
the first transmission-and-reception apparatus comprising:
a transmitter that transmits category information concerning a function of the first transmission-and-reception apparatus; and
a deinterleaver that deinterleaves the interleaved signals based on an interleaving scheme corresponding to the category information, and
the second transmission-and-reception apparatus comprising:
a receiver that receives the category information;
a selector that selects an interleaving scheme based on the category information received; and
an interleaver that interleaves signals to be transmitted to the first transmission-and-reception apparatus based on the interleaving scheme selected to generate the interleaved signals.

16. A transmission-and-reception system including a first transmission-and-reception apparatus and a second transmission-and-reception apparatus that transmits interleaved signals to the first transmission-and-reception apparatus,
the first transmission-and-reception apparatus comprising:
a transmitter that transmits category information concerning a function of the first transmission-and-reception apparatus;
a control-signal demodulator that demodulates a control signal multiplexed into the interleaved signals received and extracts information indicative of an interleaving scheme; and
a deinterleaver that deinterleaves the interleaved signals received based on the interleaving scheme extracted.
the second transmission-and-reception apparatus comprising:
a receiver that receives the category information;
a selector that selects an interleaving scheme based on the category information received;
an interleaver that interleaves signals to be transmitted to the first transmission-and-reception apparatus based on the interleaving scheme selected to generate the interleaved signals; and
a control-signal multiplexer that generates a control signal including information indicative of the interleaving scheme selected, and multiplexes the interleaved signals and the control signal.

17. A transmission-and-reception method for a transmission-and-reception system including a transmitter that transmits interleaved signals and a receiver that receives the interleaved signals, the transmission-and-reception method comprising:
a first step of the receiver transmitting category information concerning a function of the receiver;
a second step of the transmitter receiving the category information;
a third step of the transmitter selecting an interleaving scheme based on the category information received;
a fourth step of the transmitter performing interleaving based on the interleaving scheme selected to generate the interleaved signals; and
a fifth step of the receiver receiving and deinterleaving the interleaved signals based on an interleaving scheme corresponding to the category information.

18. A transmission-and-reception method for a transmission-and-reception system including a transmitter that transmits interleaved signals and a receiver that receives the interleaved signals, the transmission-and-reception method comprising:
a first step of the receiver transmitting category information concerning a function of the receiver;
a second step of the transmitter receiving the category information;
a third step of the transmitter selecting an interleaving scheme based on the category information received;
a fourth step of the transmitter generating a control signal including information indicative of the interleaving scheme selected at the third step and multiplexing the control signal and the interleaved signals;
a fifth step of the transmitter performing interleaving based on the interleaving scheme selected to generate the interleaved signals;
a sixth step of the receiver demodulating the control signal multiplexed into the interleaved signals received and extracting the interleaving scheme; and
a seventh step of the receiver deinterleaving the interleaved signals received based on the interleaving scheme extracted at the sixth step.
